# EUROPEAN PATENT SPECIFICATION

(11) **EP 4 170 997 B1**
(45) Date of publication and mention of the grant of the patent: **02.04.2025**
(21) Application number: 21868447.0
(22) Date of filing: 31.08.2021
(51) Int. Cl.: H04M 1/02, H05K 5/03, C04B 35/48, C04B 35/486, C04B 35/64, C04B 35/622, C04B 35/626, C04B 35/65, H05K 5/02

(54) **SHELL AND PREPARATION METHOD THEREFOR, AND ELECTRONIC DEVICE**
SCHALE UND HERSTELLUNGSVERFAHREN DAFÜR SOWIE ELEKTRONISCHE VORRICHTUNG
COQUE ET PROCÉDÉ DE PRÉPARATION DE CELLE-CI, ET DISPOSITIF ÉLECTRONIQUE

(30) Priority: 15.09.2020 CN 202010972084
(43) Date of publication of application: 26.04.2023
(73) Proprietor: GUANGDONG OPPO MOBILE TELECOMMUNICATIONS CORP., LTD., Dongguan, Guangdong 523860 (CN)
(72) Inventor: ZHANG, Wenyu, Dongguan, Guangdong 523860 (CN); LU, Xiangwu, Dongguan, Guangdong 523860 (CN); HOU, Tibo, Dongguan, Guangdong 523860 (CN)
(74) Representative: Grassi, Stefano
(86) International application number: PCT/CN2021/115821
(87) International publication number: WO 2022/057620

(56) References cited:
- WO-A1-2020/035330
- CN-A- 101 589 455
- CN-A- 109 640 563
- CN-A- 110 041 070
- CN-A- 111 491 055
- DE-A1- 102006 024 489

## Description

### TECHNICAL FIELD

The disclosure relates to the technical field of electronic products, and more particularly to a shell and a preparation method therefor, and an electric device.

### BACKGROUND

Ceramic materials are often used in electronic equipment in recent years because of their high hardness, good toughness, wear resistance, and other advantages. As the color of ceramic materials is relatively single, it is particularly important to improve their appearance effect and meet more diversified needs.

CN111491055A discloses a preparation method of a material and/or color gradient mobile phone shell. The preparation method comprises the following steps: S 1, preparation of various feeds for 3D printing according to a 3D printing model; S2, mobile phone shell blank printing: dividing the mobile phone shell blank into a plurality of printing areas according to the distribution of materials in the 3D printing model, and carrying out continuous printing on the plurality of printing areas to obtain a mobile phone shell blank; S3, degreasing: degreasing the green body to obtain a degreased part; and S4, sintering: sintering the degreased part to form a final product. According to the invention, multiple material printing technologies and indirect printing are combined to realize integrated molding of the mobile phone shell, and the size problem caused by assembly is avoided.

CN109640563A discloses a color ceramic, a casing, preparation methods thereof and an electronic device. The preparation method of the color ceramic comprises the steps of placing a plurality of ceramic modules in a coordinated manner, and sintering an obtained product, wherein the two ceramic modules placed adjacent to each other are different in color. Therefore, the preparation method is simple and easy to operate, the process is mature, and the industrial production is easy. According to the above preparation method, the ceramic modules of different colors are directly spliced together, the color of the obtained color ceramic is more full, the boundaries between the different colors are clear and distinct, a strong color contrast effect between different colors can be realized, and therefore, the individualization of the color ceramic is improved. By sintering, the two adjacent ceramic modules can be tightly combined to allow a plurality of ceramic modules to form a whole body, and the color ceramic with a color contrast pattern is achieved.

### SUMMARY

In view of the above, the present disclosure provides a shell and a preparation method thereof, and an electronic device. The shell presents a variety of colors, and there is a color gradation region between two colors, so that the appearance effect is rich. In addition, the shape error of boundary line between regions is small, which ensures the appearance uniformity of the shell and improves the visual aesthetics. When the shell is applied to electronic device, the appearance effect and product competitiveness can be significantly improved. The invention is set out in the appended set of claims.

### BRIEF DESCRIPTION OF DRAWINGS

In order to explain technical solutions in embodiments of the present disclosure more clearly, the following will describe the drawings required in the embodiments of the present disclosure.
FIG. 1 illustrates a schematic structural diagram of a shell according to an embodiment of the present disclosure.
FIG. 2 illustrates a schematic structural diagram of a shell according to another embodiment of the present disclosure.
FIG. 3 illustrates a schematic enlarged diagram of a portion A in FIG. 2.
FIG. 4 illustrates a top view of the shell according to the embodiment of the present disclosure.
FIG. 5 illustrates a top view of the shell according to the another embodiment of the present disclosure.
FIG. 6 illustrates a schematic structural diagram of a shell according to still another embodiment of the present disclosure.
FIG. 7 illustrates a flowchart of a preparation method of a shell according to an embodiment of the present disclosure.

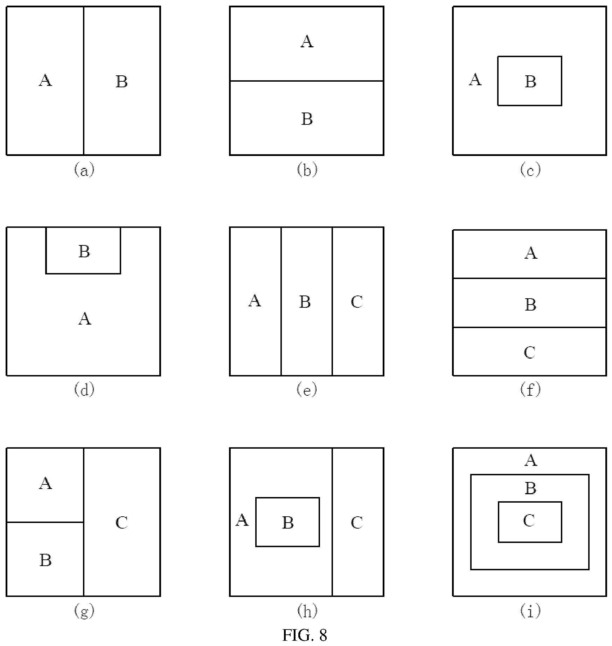

FIG. 8 illustrates a schematic structural diagram of a ceramic substrate green body according to an embodiment of the present disclosure, where (a) illustrates a schematic structural diagram of a first kind of ceramic substrate green body, (b) illustrates a schematic structural diagram of a second kind of ceramic substrate green body, (c) is illustrates a schematic structural diagram of a third kind of ceramic substrate green body, (d) illustrates a schematic structural diagram of a fourth kind of ceramic substrate green body, and (e) illustrates a schematic structural diagram of a fifth kind of ceramic substrate green body, (f) illustrates a schematic structural diagram of a sixth kind of ceramic substrate green body, (g) illustrates a schematic structural diagram of a seventh kind of ceramic substrate green body, (h) illustrates a schematic structural diagram of a eighth kind of ceramic substrate green body, and (i) illustrates a schematic structural diagram of a ninth kind of ceramic substrate green body.

### Description of reference numerals:

first region-11, second region-12, gradation region-13, first boundary line-14, second boundary line-15, ceramic substrate-10, color layer-20, shell-100.

### DETAILED DESCRIPTION OF EMBODIMENTS

The following are preferred embodiments of the present disclosure..

The following disclosure provides many different embodiments or examples for implementing different structures of the present disclosure. In order to simplify the disclosure of the present disclosure, components and settings of specific examples are described below. Of course, they are only examples and are not intended to limit the present disclosure. In addition, the present disclosure may repeat reference numerals and/or reference letters in different examples for the purpose of simplification and clarity, which is not indicative of a relationship between the various embodiments and/or arrangements discussed. Moreover, the present disclosure provides examples of various specific processes and materials, but those skilled in the art can be aware of the application of other processes and/or the use of other materials.

The present disclosure provides a shell, including a ceramic substrate, and the ceramic substrate includes a first region, a second region and a gradation region located between the first region and the second region. The first region presents a first color, the second region presents a second color, and the first region and the second region have a color difference. A direction from the first region to the second region is a first direction, and the gradation region presents a gradation from the first color to the second color along the first direction. A surface of the ceramic substrate is disposed with a first boundary line and a second boundary line, the first boundary line is located between the first region and the gradation region, the second boundary line is located between the second region and the gradation region, and a straightness of at least one of the first boundary line and the second boundary line is less than 0.5 mm.

In an embodiment, the straightness of at least one of the first boundary line and the second boundary line is less than 0.3 mm.

In an embodiment, the first boundary line is parallel to the second boundary line.

In an embodiment, a size of the gradation region in the first direction is less than or equal to 20 mm.

In an embodiment, the first region includes a first colorant, and a mass content of the first colorant in the first region is in a range of 0.1% to 10%. The second region includes a second colorant, and a mass content of the second colorant in the second region is less than or equal to 10%.

In an embodiment, the mass content of the first colorant in the first region is in a range of 4% to 10%, the mass content of the second colorant in the second region is in a range of 0% to 2%, and at least one of the first colorant and the second colorant is a non-spinel colorant.

In an embodiment, a material of the ceramic substrate includes aluminum oxide, and a mass content of the aluminum oxide in the ceramic substrate is less than 1%.

In an embodiment, the first colorant is spinel colorant.

In an embodiment, the second region includes aluminum oxide, and a mass content of the aluminum oxide in the second region is in a range of 3% to 20%.

In an embodiment, the first region includes aluminum oxide, and a mass content of the aluminum oxide in the first region is less than or equal to 20%.

In an embodiment, an optical transmittance of the second region is greater than 40%.

In an embodiment, materials of the second region include 0.2%-0.5% of aluminum oxide, 0.5%-1% of silicon dioxide, 2%-10% of stabilizer, and a balance of zirconia by mass percentages.

In an embodiment, the shell further includes a color layer disposed on the surface of the ceramic substrate, the color layer covers the second region, and the color layer has a color difference with the first region.

In an embodiment, the first region and the gradation region are arranged adjacent to each other, and the second region and the gradation region are arranged adjacent to each other.

In an embodiment, a value of the color difference between the first region and the second region is greater than 2.

In an embodiment, a density of the ceramic substrate is greater than 6 g/cm³, a flexural strength of the ceramic substrate is greater than 800 MPa, a fracture toughness of the ceramic substrate is greater than 7 MPa*m^{1/2}, a Vickers hardness of the ceramic substrate is greater than 500 HV0.1, and a surface roughness of the ceramic substrate is less than 0.01µm.

The present disclosure also provides a preparation method of a shell, including: providing a first ceramic green body and a second ceramic green body, the first ceramic green body and the second ceramic green body having a color difference, and a Vickers hardness of each of the first ceramic green body and the second ceramic green body being greater than or equal to 10 HV0.1; splicing the first ceramic green body and the second ceramic green body to obtain a spliced ceramic green body and then pressing the spliced ceramic green body to form a ceramic substrate green body, where a density difference between the first ceramic green body and the second ceramic green body in the ceramic substrate green body is less than 0.08 g/cm³; and performing glue discharging and sintering on the ceramic substrate green body to obtain a ceramic substrate, thereby obtaining the shell.

In an embodiment, the providing a first ceramic green body and a second ceramic green body includes: providing a first ceramic raw material and a second ceramic raw material, where a difference between median particle diameters D50 of the first ceramic raw material and the second ceramic raw material is less than 30 µm, a difference between apparent densities of the first ceramic raw material and the second ceramic raw material is less than 0.2g/cm³; and pre-pressing the first ceramic raw material to obtain the first ceramic green body, and pre-pressing the second ceramic raw material to obtain the second ceramic green body.

In an embodiment, the median particle size D50 of the first ceramic raw material is in a range of 50 µm-100 µm, the apparent density of the first ceramic raw material is in a range of 1.2 g/cm³ to1.8 g/cm³; the median particle size D50 of the second ceramic raw material is in a range of 50 µm to 100 µm, the apparent density of the second ceramic raw material is in a range of 1.2 g/cm³ to 1.8 g/cm³; the pre-pressing includes processing at a pressure in a range of 5 MPa-20 MPa, a density of each of the first ceramic green body and the second ceramic green body is in a range of 2.2g/cm³ to 2.5g/cm³, a density difference between the first ceramic green body and the second ceramic green body is less than 0.2 g/cm³, and a Vickers hardness of each of the first ceramic green body and the second ceramic green body is in a range of 10 HV0.1 to 70 HV0.1.

In an embodiment, the splicing the first ceramic green body and the second ceramic green body and then pressing the spliced ceramic green body to form a ceramic substrate green body includes: splicing the first ceramic green body and the second ceramic green body to form the ceramic substrate green body by final pressing and isostatic pressing, where the final pressing includes processing at a pressure in a range of 50 MPa to 80MPa, and the isostatic pressing includes processing at a pressure in a range of 100 MPa to 200 MPa.

In an embodiment, a density difference between the first ceramic green body and the second ceramic green body after the final pressing is less than 0.15 g/cm³, a density of the ceramic substrate green body after the final pressing is greater than 3 g/cm³, and a density of the ceramic substrate green body after the isostatic pressing is greater than 3.1 g/cm³.

In an embodiment, the glue discharging includes processing at a temperature in a range of 300°C to 500°C for 12 hours to 24 hours; and the sintering includes processing at a temperature in a range of 1300°C to 1500°C for 2 hours to 4 hours.

In an embodiment, after the sintering, a bonding strength between the first ceramic green body and the second ceramic green body is greater than 800 MPa, and a difference in gas porosity between the first ceramic green body and the second ceramic green body is less than 0.1%.

The present disclosure also provides an electronic device, including a shell and a main board, the shell includes a ceramic substrate, the ceramic substrate includes a first region, a second region, and a gradation region located between the first region and the second region. The first region presents a first color, the second region presents a second color, and the first region and the second region have a color difference. A direction from the first region to the second region is a first direction, and the gradation region presents a gradation from the first color to the second color along the first direction. A surface of the ceramic substrate is disposed with a first boundary line and a second boundary line, the first boundary line is located between the first region and the gradation region, the second boundary line is located between the second region and the gradation region, and a straightness of at least one of the first boundary line and the second boundary line is less than 0.5 mm.

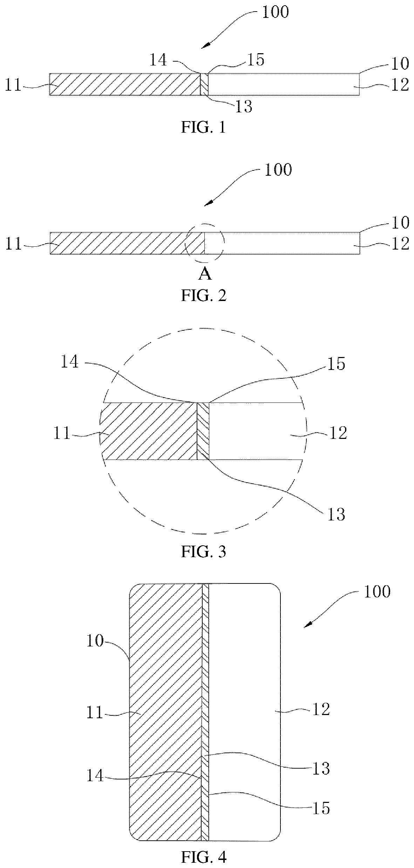

FIG. 1 illustrates a schematic structural diagram of a shell of the present disclosure. The shell 100 includes a ceramic substrate 10, which includes a first region 11, a second region 12, and a gradation region 13 located between the first region 11 and the second region 12. The first region 11 presents a first color, the second region 12 presents a second color, and the first region 11 and the second region 12 have a color difference. A direction from the first region 11 to the second region 12 is a first direction, and the gradation region 13 presents a gradation from the first color to the second color along the first direction. A surface of the ceramic substrate 10 is disposed with a first boundary line 14 and a second boundary line 15, the first boundary line 14 is located between the first region 11 and the gradation region 13, and the second boundary line 15 is located between the second region 12 and the gradation region 13. A straightness of at least one of the first boundary line 14 and the second boundary line 15 is less than 0.5 mm. In the present disclosure, by setting regions with multiple colors, and setting the gradation region 13 of color between single color regions, the ceramic assembly presents a variety of color visual effects, greatly improving the appearance of the shell 100; and meanwhile, the shape error of the boundary line between the regions is small, which ensures the appearance uniformity of the shell 100, improves the visual aesthetics, and is more conducive to its application.

In the present disclosure, the ceramic substrate 10 includes the first region 11, the second region 12, and the gradation region 13. The first region 11 and the second region 12 have a color difference. It is understood that the terms "first", "second", etc. in the present disclosure are only used for the purpose of description, and cannot be understood as indicating or implying relative importance or implying the number of indicated technical features. In the present disclosure, there may be two single color regions or more than two single color regions to form a more colorful appearance. The surface of the ceramic substrate 10 is disposed with the first boundary line 14 and the second boundary line 15, the first boundary line 14 is located between the first region 11 and the gradation region 13, and the second boundary line 15 is located between the second region 12 and the gradation region 13. That is, on the surface of the shell 100, a boundary between the first region 11 and the gradation region 13 is the first boundary line 14, and a boundary between the second region 12 and the gradation region 13 is the second boundary line 15. It can be understood that the shell 100 has a plurality of surfaces, and at least one surface of the shell has the first boundary line 14 and the second boundary line 15.

In the present disclosure, the first region 11 is adjacent to the gradation region 13, and the second region 12 is adjacent to the gradation region 13. Understandably, adjacency may be a surrounding arrangement or a side arrangement. Specifically, the surrounding may be, but is not limited to, partial surrounding, surrounding, etc. In one embodiment, the first region 11 is located on one side of the gradation region 13. In this situation, on the surface of the ceramic substrate 10, there is only a first boundary line 14 between the first region 11 and the gradation region 13. In another embodiment, the second region 12 is located on one side of the gradation region 13. In this situation, on the surface of the ceramic substrate 10, there is only a second boundary line 15 between the second region 12 and the gradation region 13. In still another embodiment, the first region 11 is arranged around the gradation region 13, or the gradation region 13 is arranged around the first region 11. In this situation, on the surface of the ceramic substrate 10, there are multiple first boundary lines 14 between the first region 11 and the gradation region 13, and the straightness of at least one of the first boundary lines 14 is less than 0.5 mm. It can be understood that at least two of the multiple first boundary lines 14 extend in different directions. In even still another embodiment, the second region 12 is arranged around the gradation region 13, or the gradation region 13 is arranged around the second region 12. In this situation, there are multiple second boundary lines 15 between the second region 12 and the gradation region 13, and the straightness of at least one second boundary line 15 is less than 0.5 mm. It can be understood that at least two of the multiple second boundary lines 15 extend in different directions.

Understandably, straightness refers to an allowable total variation of a single actual straight line, which belongs to one of the form tolerances. By controlling the straightness of the boundary lines between the regions in the ceramic substrate 10, the good uniformity of the distribution range of each region is ensured, the problems of messy color distribution and mixed visual effects are avoided, and the shell effect of the shell 100 is ensured. In the present disclosure, a two-dimensional image measuring instrument is used to focus on the first boundary line 14 and/or the second boundary line 15, equidistant points are taken from the first boundary line 14 or the second boundary line 15, a distance between two adjacent points is not more than 5 mm, at least 20 points are taken from each boundary line, a curve is fit to the obtained points, the straightness of the curve is measured, and then the straightness of the first boundary line 14 and/or the second boundary line 15 is obtained. The straightness of the curve is the maximum value of a vertical distance between the wave peak and wave trough of the curve. In an embodiment of the present disclosure, the straightness of each of the first boundary line 14 and the second boundary line 15 is less than 0.3 mm, and thus the uniformity of color distribution of ceramic substrate 10 is further improved. In another embodiment of the present disclosure, the straightness of at least one of the first boundary line 14 and the second boundary line 15 is less than 0.3 mm, and thus the regions are further improved to be more orderly and the color distribution is more harmonious. Specifically, the straightness of the first boundary line 14 and/or the second boundary line 15 may be, but not limited to, less than 0.28 mm, 0.25 mm, 0.22 mm, and 0.2 mm. In still another embodiment of the present disclosure, the first boundary line 14 is parallel to the second boundary line 15. Thus, the color distribution among the gradation region 13 and the adjacent regions is improved.

In the present disclosure, the first region 11 presents the first color, the second region 12 presents the second color, and the first region 11 and the second region 12 have a color difference. It can be understood that by controlling the ceramic material, the first region 11 or the second region 12 is made colorless and transparent, so that the shell 100 has a partial color change and a partial transparent appearance, and the visual effect is richer.

In an embodiment of the present disclosure, a value of the color difference (also referred to as color difference value) between the first region 11 and the second region 12 is greater than 2. Lab color model is not only a device-independent color model, but also a color model based on physiological characteristics. The Lab color model is composed of three elements: L, a, and b. L is used to represent brightness, a value range is [0, 100], representing from pure black to pure white; a represents a range from green to red and a value range is [-128, 127]; and b represents a range from blue to yellow and a value range is [-128, 127]. Each color has a Lab value, and the difference between two colors (i.e., color difference value) is represented by ΔE. For example, the L value of the first color is L1, a value is a1, b value is b1, and the L value of the second color is L2, a value is a2, and b value is b2, then the brightness difference between the two colors is ΔL= | L1-L2 | , the red/green difference is Δa= | a1-a2 | , the yellow/blue difference is Δb= | b1-b2 | , color difference value of two colors ΔE=(ΔL2+Δa2+Δb2)^{1/2}. In the present disclosure, by controlling that the color difference value of the first region 11 and the second region 12 is greater than 2, the color of the first region 11 and the second region 12 can be distinguished by the human eye to achieve the appearance effect of multiple colors. In another embodiment, the color difference value of the first region 11 and the second region 12 is greater than 4; and in still another embodiment, the color difference value of the first region 11 and the second region 12 is greater than 6 to produce a significant color difference and form a color contrast effect.

In an embodiment of the present disclosure, a difference between an average Lab value of the gradation region 13 and a Lab value of the first region 11 is greater than 2, and/or a difference between the average Lab value of the gradation region 13 and a Lab value of the second region 12 is greater than 2, so that the color of the gradation region 13 is obviously different from the first region 11 and the second region 12. In an embodiment, a difference between a Lab value of a middle point in the gradation region 13 and the Lab value of the first region 11 and/or the second region 12 is greater than 2, and the middle point is a point in the gradation region 13 at which the shortest distances from the first region 11 and the second region 12 are equal.

In the present disclosure, the ceramic substrate 10 has an inner surface and an outer surface opposite to the inner surface. It can be understood that the inner and outer surfaces of the ceramic substrate 10 are provided with a first region 11, a second region 12 and a gradation region 13. It can also be understood that a part of the inner surface belongs to the first region 11, a part of the inner surface belongs to the second region 12, and another part of the inner surface belongs to the gradation region 13; a part of the outer surface belongs to the first region 11, a part of the outer surface belongs to the second region 12, and another part of the outer surface belongs to the gradation region 13. In an embodiment, the color difference value of the inner and outer surfaces of the first region 11 and the interior of the ceramic substrate 10 are less than 1, that is, the first region 11 presents the first color, the color is uniformly distributed, and there is no obvious color difference. Further, the color difference value of the inner surface, the outer surface and the interior of the ceramic substrate 10 in the first region 11 is less than 0.5. In another embodiment, the color difference value of the inner and outer surfaces of the second region 12 and the interior of the ceramic substrate 10 are less than 1, that is, the second region 12 presents a second color, the color is uniformly distributed, and there is no obvious color difference. Further, the color difference value of the inner surface, the outer surface and the interior of the ceramic substrate 10 in the second region 12 is less than 0.5. In still another embodiment, the color difference value of a first detection point located on the inner surface of the gradation region 13, a second detection point located on the outer surface of the gradation region 13, and a third detection point located inside the ceramic substrate 10 of the gradation region 13 is less than 1, and further, the color difference value is less than 0.5. The first detection point, the second detection point and the third detection point are points on the same line segment with the shortest distance from the inner surface to the outer surface. That is to say, the gradation region 13 a gradation of color, and there is no significant color difference between the surface and the interior corresponding to the position, and the color of the gradation region 13 has a uniform gradation as a whole.

In the present disclosure, the gradation region 13 presents a gradation from the first color to the second color along the first direction. It can be understood that the gradation region 13 presents a gradation from the second color to the first color along an opposite direction of the first direction. In an embodiment of the present disclosure, the first region 11 has a first colorant, the second region 12 has a second colorant, the gradation region 13 includes the first colorant, and a mass content of the first colorant in the gradation region 13 decreases gradually along the first direction. That is to say, the mass content of the first colorant in the gradation region 13 decreases along the first direction until the boundary of the second region 12 and the gradation region 13, and the mass content of the first colorant reaches a minimum, or even zero. By controlling the mass content of the first colorant in the gradation region 13, the color of the gradation region 13 is further made to exhibit a gradation effect. It can be understood that when the second region 12 does not contain the second colorant, the gradation region 13 does not contain the second colorant but only the first colorant. In an embodiment, when the second region 12 has a second colorant, a mass content of the second colorant in the gradation region 13 gradually decreases in the opposite direction of the first direction. That is to say, the mass content of the second colorant in the gradation region 13 decreases along the opposite direction of the first direction until the boundary of the first region 11 and the gradation region 13, the mass content of the second colorant reaches a minimum, or even zero. In another embodiment, the mass content of the second colorant in the gradation region 13 gradually decreases in the opposite direction of the first direction and reaches zero, and then the mass content of the second colorant in the gradation region 13 continues to remain zero in the opposite direction of the first direction. In the embodiment of the present disclosure, the mass content of the first colorant in the gradation region 13 decreases linearly along the first direction, resulting in a smooth transition of the color of the gradation region 13. In another embodiment of the present disclosure, the mass content of the second colorant in the gradation region 13 decreases linearly in the opposite direction of the first direction, resulting in a smooth transition of the color of the gradation region 13.

In an embodiment of the present disclosure, a size of the gradation region 13 in the first direction is less than or equal to 20 mm. By setting the gradation region 13, the shell 100 has a very gentle color transition, and the sense of fineness is enhanced. Further, the size of the gradation region 13 in the first direction is 50 µm-10mm. Furthermore, the size of the gradation region 13 in the first direction is less than or equal to 200 µm. In this way, the shell 100 presents a very strong color contrast effect, and the color contrast lines are clear. Specifically, the size of the gradation region 13 in the first direction may be, but is not limited to, 60 µm, 150 µm, 500 µm, 1 mm, 6 mm, 15 mm or 18 mm. In the present disclosure, a width of the gradation region 13 is the minimum size of the gradation region 13 in the first direction. In one embodiment, the width of the gradation region 13 is less than or equal to 20 mm, and further, the width of the gradation region 13 is less than or equal to 10 mm. In another embodiment, the width of the gradation region 13 is 50 µm-10mm. By controlling the size of the gradation region 13 in the first direction, the visual effect of the shell 100 is enriched, which is conducive to its application in electronic equipment and improves the appearance selectivity of the product. It can be understood that the straightness value of the first boundary line 14 and/or the second boundary line 15 is smaller than the size of the gradation region 13 in the first direction.

FIG. 2 illustrates a schematic structural diagram of a shell according to another embodiment of the present disclosure. The shell 100 includes a ceramic substrate 10, and the ceramic substrate 10 includes a first region 11 and a second region 12. FIG. 3 illustrates an enlarged schematic diagram of a portion A in FIG. 2. There is also a gradation region 13 located between the first region 11 and the second region 12. In this situation, a size of the gradation region 13 in the first direction is small, and it is difficult to be recognized by the naked eye, thus showing a clear boundary between the first region 11 and the second region 12, forming an obvious color contrast effect, greatly improving the appearance of the shell 100, enriching the visual effect of the shell 100, and more conducive to its application.

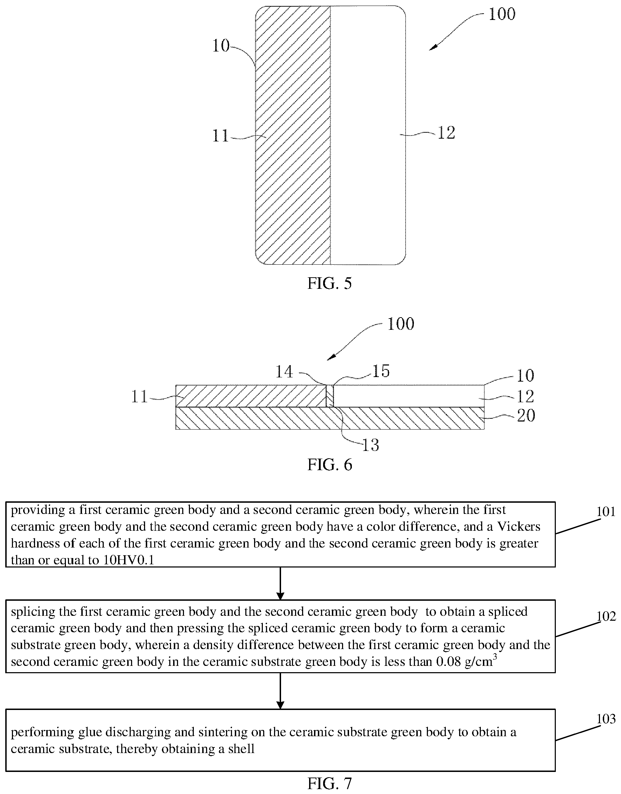

FIG. 4 illustrates a top view of the shell according to an embodiment of the present disclosure. The surface of the shell 100 is provided with a first region 11, a second region 12 and a gradation region 13 located between the first region 11 and the second region 12. The first region 11 and the second region 12 have a color difference, so that the gradation region 13 shows a slow transition of color. In this situation, the gradation region 13 has a larger size in the first direction and can be observed by naked eyes, so that the shell 100 shows a gentle color splicing effect. Specifically, the size of the gradation region 13 in the first direction may be, but is not limited to, greater than 1 mm, 3 mm, 5 mm or 10 mm. FIG. 5 illustrates a top view of the shell according to another embodiment of the present disclosure, the surface of the shell 100 is provided with a first region 11 and a second region 12. The size of the gradation region 13 located between the first region 11 and the second region 12 is small in the first direction, which cannot be observed by the naked eye. The shell 100 is presented as a clear boundary, so that the shell 100 presents a clear color contrast effect. Specifically, the size of the gradation region 13 in the first direction can, but is not limited to, not more than 1mm, 0.5 mm, 0.2 mm or 0.1 mm.

In the present disclosure, the first region 11 includes the first colorant. That is to say, the first region 11 presents the first color because of the presence of the first colorant. The first colorant may include a colorant of one color uniformly distributed in the first region 11. The first colorant may include colorants of different colors, which are uniformly distributed in the first region 11. In one embodiment, a mass content of the first colorant in the first region 11 is 0.1%-10%. In another embodiment, the mass content of the first colorant in the first region 11 is 4%-10%. In the present disclosure, by controlling the mass content of the first colorant in the first region 11, the mechanical strength of the ceramic substrate 10 is prevented from being affected by excessive colorant content. Further, the mass content of the first colorant in the first region 11 is 4%-8%. Furthermore, the mass content of the first colorant in the first region 11 is 6%-8%, deepening the color of the first region 11.

In an embodiment of the present disclosure, the second region 12 includes a second colorant. That is to say, the second region 12 presents a second color due to the presence of the second colorant. The second colorant may include a colorant of one color uniformly distributed in the second region 12. The second colorant may include colorants of different colors, which are uniformly distributed in the second region 12. In one embodiment, the mass content of the second colorant in the second region 12 is less than or equal to 10%.

In an embodiment of the present disclosure, the mass content of the first colorant in the first region 11 is 4%-10%, the mass content of the second colorant in the second region 12 is 0%-2%, and at least one of the first colorant and the second colorant is a non-spinel colorant. In this situation, the size of the gradation region 13 in the first direction is greater than 5 mm. Further, the mass content of the first colorant in the first region 11 is 4%-8%, and the mass content of the second colorant in the second region 12 is 0%-1%. In this case, the size of the gradation region 13 in the first direction is greater than 10 mm. In another embodiment, when the mass content of the second colorant in the second region 12 is 0%, that is, when there is no second colorant, the second region 12 presents the color of the ceramic material itself. In this situation, the size of the gradation region 13 in the first direction is larger than 15 mm. In one embodiment, the size of the gradation region 13 in the first direction is not greater than 20 mm. In a specific embodiment, the mass content of the first colorant in the first region 11 is 4%-10%, and the mass content of the second colorant in the second region 12 is 0%, so that the color of the first colorant can be more prominent in the gradation region 13.

In the present disclosure, at least one of the first colorant and the second colorant is a non-spinel colorant. A general chemical formula of spinel structure is AB₂O₄, A is a divalent metallic cation, which may be but not limited to at least one of Mg²⁺, Mn²⁺, Ni²⁺, Zn²⁺, Co²⁺, Cd²⁺, Cu²⁺, Ca²⁺, and B is a trivalent metallic cation, which may be but not limited to at least one of Fe³⁺, Cr³⁺, and Mn³⁺. In the spinel crystal structure, oxygen ions are closely stacked in cubic form, the divalent cations are filled in one-eighth of the tetrahedral interstices, and the trivalent cations are filled one-half of the octahedral interstices. It can be understood that the first colorant and the second colorant both are non-spinel colorants, or one of the first colorant and the second colorant is a non-spinel colorant, and the other of the first colorant and the second colorant is a mixture of the spinel colorant and the non-spinel colorant, or no colorant. In an embodiment, the first colorant and the second colorant may be, but are not limited to, a colorant selected from the group consisting of iron oxide, cobalt oxide, cerium oxide, cesium oxide, nickel oxide, bismuth oxide, zinc oxide, manganese oxide, chromium oxide, praseodymium oxide, neodymium oxide, strontium oxide, lanthanum oxide, erbium oxide, gallium oxide, silicon oxide, magnesium oxide, calcium oxide, copper oxide, vanadium oxide, tin oxide, titanium oxide, and at least one of other compounds having the above cations. For example, the other compounds having the above cations may be, but are not limited to, nickel silicate, vanadium-zirconium yellow, and the like. It is understood that the first colorant and the second colorant may also select other colorants not listed above.

In another embodiment of the present disclosure, a material of ceramic substrate 10 includes aluminum oxide, and a mass content of aluminum oxide in the ceramic substrate 10 is less than 1%. Further, the mass content of aluminum oxide in the ceramic substrate 10 is less than 0.5%. In this way, the inhibiting effect of an excessive aluminum oxide content on the diffusion of the colorant is avoided, which is beneficial to obtaining a gradation region 13 with a size greater than 5 mm in the first direction.

In the present disclosure, the gradation region 13 presents the gradation from the first color to the second color along the first direction. It can be understood that the gradation region 13 presents the gradation from the second color to the first color along the opposite direction of the first direction, and meanwhile, the size of the gradation region 13 in the first direction is greater than 5 mm. By setting the gradation region 13, the shell 100 has a very gentle color transition, and the sense of fineness is enhanced. Further, the size of the gradation region 13 in the first direction is greater than 10 mm. In the present disclosure, a width of the gradation region 13 is a minimum size of the gradation region 13 in the first direction. In one embodiment, the width of the gradation region 13 is greater than 5 mm; Further, the width of the gradation region 13 is greater than 10 mm. In another embodiment, the width of the gradation region 13 is less than 20 mm. By controlling the size of the gradation region 13 in the first direction, the visual effect of the shell 100 is enriched, which is conducive to its application in electronic products and improves the appearance selectivity of the product.

In an embodiment of the present disclosure, the first colorant is a spinel colorant. In the present disclosure, the use of spinel colorant is beneficial to the generation of narrow gradation region 13. In an embodiment of the present disclosure, the second colorant is a spinel colorant, a non-spinel colorant, or a mixture of the spinel colorant and the non-spinel colorant. In one embodiment, the size of the gradation region 13 in the first direction is less than 200 µm. By setting the gradation region 13, the shell 100 has a very obvious color contrast effect and improves the appearance expressiveness. Further, the size of the gradation region 13 in the first direction is less than 150 µ m. By controlling the size of the gradation region 13 in the first direction, the visual effect of the shell 100 is enriched, which is conducive to its application in electronic products and improves the appearance selectivity of the product.

In another embodiment of the present disclosure, the second region 12 includes aluminum oxide, and a mass content of the aluminum oxide in the second region 12 is greater than or equal to 3%. The aluminum oxide can play a role of stabilizing the colorant and can also play a role of inhibiting the diffusion of the colorant, which is conducive to reducing the size of the gradation region 13 in the first direction, so that the size of the gradation region 13 in the first direction is less than 200 µm. If the mass content of the aluminum oxide in the second region 12 is too low, it is not conducive to getting a narrow gradation region 13. Further, the mass content of aluminum oxide in the second region 12 is 3%-20%. In this situation, the presence of the aluminum oxide can not only ensure the generation of narrow gradation region 13, but also will not affect the performance of the ceramic substrate 10 and the shell 100. Furthermore, the mass content of aluminum oxide in the second region 12 is 5%-15%. In another embodiment of the present disclosure, the first region 11 includes aluminum oxide, and a mass content of the aluminum oxide in the first region 11 is less than or equal to 20%. Further, the mass content of aluminum oxide in the first region 11 is 5%-15%. Furthermore, the mass content of aluminum oxide in the first region 11 is 6%-10%. In this case, it is advantageous to reduce the size of the gradation region 13 in the first direction, thereby obtaining a narrower gradation region 13.

In an embodiment of the present disclosure, a particle size of the first colorant is 100 nanometers (nm)-2000 nm, and a particle size of the second colorant is 100 nm-2000 nm. The first colorant and the second colorant may include colorants of different colors. The particle sizes of the colorants of different colors may be the same or different, and the particle sizes of the first colorant and the second colorant may be the same or different. In one embodiment, when the first colorant includes colorants of different colors, the particle size of the colorant of each color in the first colorant is 100 nm-2000 nm; and when the second colorant includes colorants of different colors, the particle size of the colorant of each color in the second colorant is 100 nm-2000 nm. In the present disclosure, the colorant with the particle size of 100 nm-2000 nm is used to make the colorant uniformly distributed in the ceramic substrate 10 without agglomeration during the preparation of the ceramic substrate 10, thereby ensuring the mechanical strength of the ceramic substrate 10 and the shell 100, and improving the uniformity and fineness of the color of the shell 100. Further, the particle size of the first colorant is 500 nm-1000 nm, and the particle size of the second colorant is 500 nm-1000 nm. Furthermore, the particle size of the first colorant is 600 nm-900 nm, and the particle size of the second colorant is 600 nm-900 nm, which is conducive to enhancing the coloring effect and the uniformity of the appearance color of the shell 100.

In an embodiment of the present disclosure, a particle size of aluminum oxide is 100 nm-2000 nm. By using the aluminum oxide with the particle size of 100nm-2000nm, not only the uniform distribution of aluminum oxide in the ceramic substrate 10 can be ensured, but also make the mechanical properties of the ceramic substrate 10 and the shell 100 excellent. In addition, it is not easy to agglomerate, and can be better distributed around the colorant, which can fully hinder the diffusion of the colorant, and is more conducive to the production of a narrower gradation region 13. Further, the particle size of the aluminum oxide is 500 nm-1600 nm. Furthermore, the particle size of the aluminum oxide is 600 nm-1000 nm. Specifically, the particle size of the aluminum oxide may be, but is not limited to, 100 nm, 300 nm, 500 nm, 800 nm, 1200 nm, 1500 nm or 1700 nm.

In an embodiment of the present disclosure, the ceramic substrate 10 is a zirconia-based ceramic. That is to say, the material of the ceramic substrate 10 is mainly zirconia, and the zirconia-based ceramic has excellent toughness, strength and hardness, which improves the mechanical properties and resistance of the ceramic substrate 10 and the shell 100 and is conducive to its application. In an embodiment of the present disclosure, the materials of the ceramic substrate 10 includes zirconia, a stabilizer, a first colorant and a second colorant. In an embodiment, a particle size of zirconia is 100 nm-500 nm, and thus the ceramic substrate 10 having a fine texture can be advantageously formed. Further, the particle size of zirconia is 200 nm-300 nm. Specifically, the particle size of zirconia may be, but is not limited to, 120 nm, 160 nm, 190 nm, 230 nm, 250 nm, 380 nm or 450 nm. In an embodiment, the stabilizer may include, but is not limited to, at least one of yttrium oxide, hafnium oxide, lanthanum oxide, cerium oxide, scandium oxide, calcium oxide, magnesium oxide, ytterbium oxide and tantalum oxide. In the present disclosure, adding stabilizer is conducive to forming stable and dense zirconia crystal phase in the finally prepared ceramic substrate 10, so as to improve the performance of the ceramic substrate 10. In an embodiment, a mass content of the stabilizer in the ceramic substrate 10 is 3%-10%. Further, the mass content of stabilizer in ceramic substrate 10 is 4%-6%. In a specific embodiment, the stabilizer in the ceramic substrate 10 is yttrium oxide and hafnium oxide. The yttrium oxide ensures that the ceramic substrate 10 has a high content of tetragonal phase and makes the ceramic substrate 10 have a good stability, preventing the ceramic substrate 10 from cracking during sintering and processing. The hafnium oxide is the companion of the zirconia, both of which have similar physical and chemical properties and play a stabilizing role in the ceramic substrate 10. In another specific embodiment, tetragonal phase zirconia in the ceramic substrate 10 accounts for more than 70% of a mass of zirconia.

It can be understood that the second region 12 may be colorless and transparent without adding colorants by controlling the ceramic material, so that the shell 100 has a partial color change and a partial transparent appearance, and the visual effect is richer. In an embodiment of the present disclosure, an optical transmittance of the second region 12 is greater than 40%. Further, the optical transmittance of the second region 12 is greater than 50%. Furthermore, the optical transmittance of the second region 12 is greater than 60%. The optical transmittance is the transmittance of light in the band of 380 nm-780 nm. Thus, the second region 12 can present a transparent appearance and enrich the visual effect of the shell 100. In an embodiment, materials of the second region 12 include 0.2%-0.5% of aluminum oxide, 0.5%-1% of silicon dioxide, 2%-10% of stabilizer, and a balance of zirconia in mass percentage. Further, by the mass percentage, the materials of the second region 12 include 0.2%-0.4% of aluminum oxide, 0.5%-0.8% of silicon dioxide, 2%-8% of stabilizer, and a balance of zirconia. Thus, the optical transmittance of the second region 12 is greater than 50%. The aluminum oxide improves the brightness of the ceramic substrate 10, so that the shell 100 has a high transmittance, and can ensure the mechanical properties of the ceramic substrate 10 and the shell 100. The silicon dioxide improves the acid resistance and high temperature resistance of the ceramic substrate 10, and can also adjust the color of the ceramic substrate 10 to improve the brightness of the shell 100.

FIG. 6 illustrates a schematic structural diagram of the shell according to still another embodiment of the present disclosure. The shell 100 further includes a color layer 20 on the surface of the ceramic substrate 10, and the color layer 20 covers the second region 12. In the present disclosure, the color layer 20 may cover only the second region 12, may also cover the second region 12 and the gradation region 13, and may also cover the second region 12, the gradation region 13 and the first region 11. In an embodiment, the color layer 20 and the first region 11 have a color difference, so that the shell presents a variety of color changes. In an embodiment, the color difference value between the color layer 20 and the first region 11 is greater than 2, thus making the shell 100 have an obvious color contrast effect. In an embodiment, the color layer 20 may be directly attached to the surface of the shell 100, and may also be located on the surface of the shell 100 by spraying. By setting the color layer 20, the shell 100 can present a more diversified color selection. In an embodiment, the color layer 20 has a solid color, and is located on the inner surface of the shell 100, so that the outer surface of the shell 100 directly presents an appearance with a final color contrast effect. In another embodiment of the present disclosure, the color layer 20 is a transparent color layer. In this situation, the color layer 20 can be located on either the inner surface of the shell 100 or the outer surface of the ceramic assembly. Thus, the shell 100 can present the appearance effect of various colors.

The flexural strength refers to the ability of ceramic substrate 10 to resist bending without breaking. Generally, three-point bending test method or four point bending test method is adopted for evaluation. In the present disclosure, the three-point flexural strength of the ceramic substrate 10 is tested by using "GB/T 6569-2006 Fine ceramics (advanced ceramics, advanced technical ceramics)-Test method for flexural strength of monolithic ceramics at room temperature". In an embodiment of the present disclosure, the flexural strength of the ceramic substrate 10 is greater than 800 MPa. Further, the flexural strength of ceramic substrate 10 is greater than 900 MPa. The flexural strength of the ceramic substrate 10 in the present disclosure is excellent, thereby ensuring the flexural strength of the shell 100, so that it has a better application prospect.

The fracture toughness refers to a resistance value of a material when there are cracks or crack-like defects in the ceramic substrate 10, starting from which the ceramic substrate 10 no longer breaks rapidly with the increase of load, that is, when the so-called unstable fracture occurs. The fracture toughness represents the ability of materials to prevent crack propagation and is a quantitative index to measure the toughness of materials. In the present disclosure, the fracture toughness of the ceramic substrate 10 is tested by three-point bending in GB/T 23806-2009 Fine ceramics(advanced ceramics, advanced technical ceramics)-Test method for fracture toughness of monolithic ceramics at room temperature by single edge pre-cracked beam (SEPB) method. In the embodiment of the present disclosure, the fracture toughness of the ceramic substrate 10 is greater than 7 MPa*m^{1l2}. Further, the fracture toughness of the ceramic substrate 10 is greater than 7.5 MPa*m^{1/2}. The ceramic substrate 10 of the present has good fracture toughness and excellent brittle fracture resistance, ensuring that the shell 100 has excellent performance.

The hardness characterizes the ability of the ceramic substrate 10 to resist hard objects pressing into its surface. The standard format of a value of the Vickers hardness is xHVy. The value x before HV is a hardness value, and the value y after HV is the test force. The ceramic substrate 10 is tested by a Vickers hardness tester. In an embodiment of the present disclosure, the Vickers hardness of the ceramic substrate 10 is greater than 500HV0.1. Further, the Vickers hardness of the ceramic substrate 10 is greater than 600HV0.1. The ceramic substrate 10 of the present disclosure has high hardness and good deformation resistance.

In an embodiment of the present disclosure, the surface roughness of the ceramic substrate 10 is less than 0.01 µm. By providing the ceramic substrate 10 with a small surface roughness, the surface smoothness of the ceramic substrate 10 is further enhanced. In the embodiment of the present disclosure, the surface roughness of the shell 100 is less than 0.01 µm, which is beneficial to its application in electronic devices.

The density and porosity of the ceramic substrate 10 is tested by adopting GB/T 25995-2010 Test methods for density and apparent porosity of fine ceramics. In an embodiment of the present disclosure, the density of the ceramic substrate 10 is greater than 6 g/cm³. In another embodiment of the present disclosure, the porosity of the ceramic substrate 10 is less than 1%. That is, the compact density of ceramic substrate 10 is greater than 99%. The density and low porosity of the ceramic substrate 10 ensure the internal bonding strength of the ceramic substrate 10, which is conducive to improving the mechanical properties of the shell 100.

FIG. 7 illustrates a flowchart of a preparation method of a shell according to an embodiment of the present disclosure. The preparation method for preparing the shell 100 of any of the above embodiments includes the following a block 101 through a block 103.

At the block 101: providing a first ceramic green body and a second ceramic green body, where the first ceramic green body and the second ceramic green body have a color difference, and a Vickers hardness of each of the first ceramic green body and the second ceramic green body is greater than or equal to 10HV0.1.

At the block 102: splicing the first ceramic green body and the second ceramic green body and then pressing the spliced ceramic green body to form a ceramic substrate green body, where a density difference between the first ceramic green body and the second ceramic green body in the ceramic substrate green body is less than 0.08 g/cm³.

At the block 103: performing glue discharging and sintering on the ceramic substrate green body to obtain a ceramic substrate, thereby obtaining the shell.

In the present disclosure, by controlling the hardness and the density difference, the ceramic green bodies are prevented from deformation and distortion in the whole dry pressing process, and the shrinkage rates of the adjacent ceramic green bodies are ensured to be consistent, so that the ceramic substrate 10 and the shell 100 with excellent straightness are prepared. There are a number of ceramic green bodies with different colors in the ceramic substrate green body, and during the sintering process of the adjacent first ceramic green body and the second ceramic green body, the colorant in the ceramic green body will be diffused, and color mixing will occur near the splicing surface, forming the gradation region 13 different from the first color and the second color. In the present disclosure, by controlling the density difference between the first ceramic green body and the second ceramic green body, the straightness of the boundary line between the regions in the prepared shell 100 is less than 0.5 mm.

It can be understood that the first ceramic green body presents the first color, the second ceramic green body presents the second color, the first ceramic green body after sintering forms the first region 11 and a part of the gradation region 13, and the second ceramic green body after sintering forms the second region 12 and a part of the gradation region 13. On the surface of the shell 100 of the present disclosure, there is a first boundary line 14 between the first region 11 and the gradation region 13, and a second boundary line 15 between the second region 12 and the gradation region 13, but it is not a seam line.

In an embodiment of the present disclosure, the providing a first ceramic green body and a second ceramic green body includes: providing a first ceramic raw material and a second ceramic raw material, where a difference of a median particle diameter D50 between the first ceramic raw material and the second ceramic raw material is less than 30 µm, a difference of an apparent density between the first ceramic raw material and the second ceramic raw material is less than 0.2g/cm³; pre-pressing the first ceramic raw material to obtain the first ceramic green body, and pre-pressing the second ceramic raw material to obtain the second ceramic green body. Thus, by controlling the difference in median particle size D50 and apparent density between the first ceramic raw material and the second ceramic raw material, it is beneficial to make the density difference between the first ceramic green body and the second ceramic green body in the ceramic substrate green body less than 0.08 g/cm³, and to obtain better straightness of the first boundary line 14 and the second boundary line 15. Further, the difference between the median particle size D50 of the first ceramic raw material and the second ceramic raw material is less than 25 µm, and the difference between the apparent density of the first ceramic raw material and the second ceramic raw material is less than 0.16 g/cm³.

In an embodiment of the present disclosure, the first ceramic raw material is formed by granulating after mixing first ceramic powder and a first organic auxiliary agent. In an embodiment of the present disclosure, the first ceramic powder includes zirconia, a stabilizer and a first colorant. In an embodiment, in terms of the mass percentage, the stabilizer in the first ceramic powder accounts for 3%-10%, the first colorant accounts for less than 20%, and the remainder is zirconia. Further, in terms of mass percentage, the stabilizer in the first ceramic powder accounts for 3%-10%, the first colorant accounts for 1%-20%, and the zirconia accounts for 70%-95%.

In an embodiment of the present disclosure, a mass ratio of the first organic auxiliary agent to the first ceramic powder is (0.01-0.2): 1. Further, the mass ratio of the first organic auxiliary agent to the first ceramic powder is (0.01-0.1): 1. In the subsequent glue discharge and sintering process, the first organic auxiliary agent is completely discharged after decomposition or volatilization. In an embodiment, the first organic auxiliary includes a binder. Specifically, the binder may include, but is not limited to, at least one of polymethyl methacrylate, polyvinyl butyral, polyethylene and polyethylene glycol. By providing the binder, the components in the first ceramic powder can be uniformly dispersed in the first organic auxiliary agent, and the strength of the first ceramic green body is enhanced by the action of the binder between the components. In an embodiment, a value of a mass ratio of the binder to the first ceramic powder is greater than 0.03. Thus, the hardness of the first ceramic green body is improved, the overall strength in the pressing process is improved, and the deformation of the green body in the pressing process is avoided. Further, a value of the mass ratio of the binder to the first ceramic powder is greater than 0.05. In another embodiment, the first organic auxiliary agent may, but is not limited to, include at least one of a binder, an organic solvent, a plasticizer, a dispersant, a defoamer, and a lubricant. Specifically, the organic solvent may, but is not limited to, include at least one of absolute alcohol, toluene and ethylene glycol, the plasticizer may, but is not limited to, include at least one of dibutyl phthalate, dioctyl phthalate and butyl benzyl phthalate, the dispersant may be, but is not limited to, triethanolamine, the defoamer may, but is not limited to, dimethyl siloxane, and the lubricant may be, but is not limited to, at least one of stearic acid and paraffin. In the present disclosure, when the first organic auxiliary agent contains multiple components, the proportion of each component can be selected according to the needs of the subsequent preparation process, and the types of components in the first organic auxiliary can be added as needed.

In an embodiment of the present disclosure, the first ceramic powder and the first organic auxiliary agent are mixed to form a first ceramic slurry, and the first ceramic slurry is made into the first ceramic raw material after spray granulation. In an embodiment, the outlet temperature of a spray dryer during the spray granulation may be, but is not limited to, 150°C-250°C. In another embodiment, the median particle size D50 of the first ceramic raw material obtained by granulation is 50 µm-100 µm, and the apparent density is 1.2 g/cm³-1.8 g/cm³. Further, the medium particle size D50 of the first ceramic raw material is 55 µm-90 µm, and the apparent density is 1.25 g/cm³-1.7 g/cm³. Thus, it is beneficial to the preparation of the first ceramic green body and further reduces the density difference with the second ceramic green body.

In an embodiment of the present disclosure, the second ceramic raw material is formed by granulating after mixing the second ceramic powder and the second organic auxiliary agent. In an embodiment of the present disclosure, the second ceramic powder includes zirconia, a stabilizer and a second colorant. In an embodiment, the stabilizer accounts for 3%-10% of the second ceramic powder, the second colorant accounts for less than 20% of the second ceramic powder, and the remainder is the zirconia in terms of mass percentage. Further, the stabilizer accounts for 3%-10% of the second ceramic powder, the second colorant accounts for 1%-20% of the second ceramic powder, and the zirconia accounts for 70%-95% of the second ceramic powder in terms of the mass percentage. Specifically, the first colorant and the second colorant may be the same colorant, but with different mass contents in ceramic powder, they may also be different colorants. The first colorant and the second colorant may be one colorant or a mixture of multiple colorants. In an embodiment, the mass content of the first colorant or the second colorant is zero to make the ceramic green body present the color of the ceramic material itself. Specifically, the types and particle sizes of the first colorant and the second colorant may be selected according to the types and particle sizes of the above colorants, which will not be repeated here.

In an embodiment of the present disclosure, a mass ratio of the second organic auxiliary agent to the second ceramic powder is (0.01-0.2): 1. Further, the mass ratio of the second organic auxiliary agent to the second ceramic powder is (0.01-0.1): 1. In the subsequent glue discharge and sintering process, the second organic auxiliary agent is completely discharged after decomposition or volatilization. In an embodiment, the second organic auxiliary includes a binder. Specifically, the binder may include, but is not limited to, at least one of polymethyl methacrylate, polyvinyl butyral, polyethylene and polyethylene glycol. By providing the binder, the components in the second ceramic powder may be uniformly dispersed in the second organic auxiliary agent, and the strength of the second ceramic green body is enhanced by the action of the binder between each component. In an embodiment, a value of the mass ratio of the binder to the second ceramic powder is greater than 0.03. Thus, the hardness of the second ceramic green body is improved, the overall strength in the pressing process is improved, and the deformation of the green body in the pressing process is avoided. Further, a value of the mass ratio of the binder to the second ceramic powder is greater than 0.05. In another embodiment, the second organic auxiliary agent may, but is not limited to, include at least one of a binder, an organic solvent, a plasticizer, a dispersant, a defoamer and lubricant. Specifically, the organic solvent may, but is not limited to, include at least one of absolute alcohol, toluene and ethylene glycol, the plasticizer may, but is not limited to, include at least one of dibutyl phthalate, dioctyl phthalate and butyl benzyl phthalate, the dispersant may be, but is not limited to, triethanolamine, the defoamer may be, but is not limited to, dimethyl siloxane, and the lubricant may be, but is not limited to, at least one of stearic acid and paraffin. In the present disclosure, when the second organic auxiliary contains multiple components, the proportion of each component may be selected according to the needs of the subsequent preparation process, and the types of components in the second organic auxiliary may be added as needed.

In an embodiment of the present disclosure, the second ceramic powder and the second organic auxiliary agent are mixed to form a second ceramic slurry, and the second ceramic slurry is made into the second ceramic raw material after spray granulation. In an embodiment, the outlet temperature of the spray dryer during the spray granulation may be, but is not limited to, 150°C-250°C. In another embodiment, the median particle size D50 of the second ceramic raw material obtained by granulation is 50 µm-100 µm. The apparent density is 1.2g/cm³-1.8g/cm³. Further, the medium particle size D50 of the second ceramic raw material is 55 µm-90 µm, and the apparent density is 1.25g/cm³-1.7g/cm³. Thus, it is beneficial to the preparation of the second ceramic green body and further reduces the density difference with the first ceramic green body.

In the present disclosure, by controlling the content and type of colorants in the first ceramic powder and the second ceramic powder, the diffusion range of the first colorant and the second colorant is wider, forming a wide gradation region 13.

In an embodiment of the present disclosure, the first ceramic powder includes the first colorant, the second ceramic powder includes the second colorant, the mass content of the first colorant in the first ceramic powder is 4%-10%, the mass content of the second colorant in the second ceramic powder is 0%-2%, and at least one of the first colorant and the second colorant is a non-spinel colorant. Thus, a size of the gradation region 13 in the ceramic substrate 10 in the first direction is greater than 5 mm.

In the present disclosure, when the content of the first colorant is too low or the content of the second colorant is too high, it is impossible to guarantee that the size of the gradation region 13 in the first direction is greater than 5 mm; and when the content of the first colorant is too high, it is not conducive to the mechanical properties of the first ceramic green body and it will affect the selection of sintering temperature, thus it is impossible to ensure that the shrinkage rates of the first ceramic green body and the second ceramic green body are similar during sintering. Thus, by using the first colorant and the second colorant with the above content, the present disclosure can not only make the shell 100 present a gradation region 13 with obvious color transition, but also ensure the performance of the shell 100. In an embodiment, the mass content of the first colorant in the first ceramic powder is 6%-10%, and the mass content of the second colorant in the second ceramic powder is 0%-1%, thus making the size of the gradation region 13 in the first direction larger than 10 mm. In another embodiment, the size of the gradation region 13 in the first direction is less than or equal to 20 mm. In the present disclosure, a content difference between the first colorant and the second colorant is greater than 2%. Further, the content difference between the first colorant and the second colorant is greater than 4%, further improving the visual effect of the gradation region 13. It may be understood that by controlling the content and color of the first colorant and the second colorant, the first ceramic green body and the second ceramic green body prepared subsequently have a color difference. At least one of the first colorant and the second colorant is a non-spinel colorant. The non-spinel colorant has good thermal diffusivity, which may be rapidly diffused during the sintering process, thus forming a wide gradation region 13, which enhances the appearance effect of the shell 100. In an embodiment, when the mass content of the second colorant in the second ceramic powder is 0%, the first colorant is the non-spinel colorant, which is more conducive to the generation of a wide size gradation region 13. In another embodiment, the first colorant and the second colorant are both non-spinel colorants, which is more conducive to the generation of a wide size gradation region 13. In an embodiment of the present disclosure, the thermal diffusion temperature of the first colorant and the second colorant is lower than the sintering temperature. In one embodiment, the atomic diffusion temperature of the first colorant and the second colorant is lower than the sintering temperature, so that the gradation region 13 can appear during the sintering process.

In another embodiment of the present disclosure, the first ceramic powder does not contain aluminum oxide, which is conducive to the formation of a wide gradation region 13. In still another embodiment of the present disclosure, the first ceramic powder includes aluminum oxide. In the present disclosure, the aluminum oxide is dispersed in the first ceramic powder and distributed in the first ceramic green body, and it is dispersed around zirconia grains and colorants. During sintering, it plays a pinning role in the diffusion of colorants, inhibits the diffusion of colorants, and thus affects the generation of a wide gradation region 13. In an embodiment, the aluminum oxide in the first ceramic powder accounts for less than 1% by mass percentage. Thus, a gradation region 13 with a gentle color transition is prepared, and the size of the gradation region 13 in the first direction is greater than 8 mm. In another embodiment, the aluminum oxide accounts for less than 1% of the second ceramic powder. Further, the second ceramic powder does not contain the aluminum oxide, which is conducive to the formation of a wide gradation region 13.

In the present disclosure, by controlling the content and type of the first colorant and the content of aluminum oxide in the second ceramic powder, the diffusion range of the first colorant and the second colorant is small, forming a narrow gradation region 13.

In an embodiment of the present disclosure, the first ceramic powder includes the first colorant, the first colorant is a spinel colorant, the mass content of the first colorant in the first ceramic powder is 0.1%-10%, the second ceramic powder includes aluminum oxide, and the mass content of aluminum oxide in the second ceramic powder is greater than or equal to 3%. Thus, the size of the gradation region 13 in the shell 100 in the first direction is less than 200 µm.

In the present disclosure, when the content of the first colorant is too high, it is not conducive to the mechanical properties of the first ceramic green body, and it will affect the selection of sintering temperature, so that the shrinkage rates of the ceramic green bodies during sintering cannot be guaranteed to be similar, and the diffusion range of the first colorant is wide, which is not conducive to the generation of the narrow gradation region 13. When the content of the first colorant is too low, the first ceramic green body cannot present obvious color, which is not conducive to the presentation of the color contrast effect. Therefore, by using the first colorant with the above content, the present disclosure can not only make the shell 100 present a narrow and obvious gradation region 13, but also ensure the performance of the shell 100. The spinel colorant has excellent structural stability and high temperature stability. During sintering, the thermal diffusion of the spinel colorant is slow, which is conducive to making the size of gradation region 13 in the first direction smaller than 200 µm. Further, the mass content of the first colorant in the first ceramic powder is 0.5%-8%. Furthermore, the mass content of the first colorant in the first ceramic powder is 1%-5%. Specifically, the mass content of the first colorant in the first ceramic powder may be, but is not limited to, 0.1%, 0.5%, 1%, 3%, 5%, 7% or 9%. Thus, the size of the gradation region 13 in the first direction may be further reduced, so that the gradation region 13, which is approximately a boundary line, is formed on the final shell 100, and its appearance presents an obvious color contrast effect. The aluminum oxide can hinder the diffusion of the colorant, and under a high temperature condition, a part of aluminum oxide can enter the spinel structure, further improving the stability of the spinel colorant and further reducing the diffusion speed of the colorant, and the other part of aluminum oxide is uniformly distributed around the colorant, which plays a pinning role in the colorant, further inhibiting the diffusion of the colorant, thus facilitating the formation of a narrow gradation region 13, and improving the clarity of the color contrast line between the first region 11 and the second region 12. By controlling the mass content of aluminum oxide in the second ceramic powder to be more than 3%, the blocking effect of aluminum oxide on the colorant during sintering is ensured, so that a gradation region 13 with a size less than 200 µm in the first direction can be formed. In an embodiment of the present disclosure, the mass content of aluminum oxide in the second ceramic powder is 3%-20%. Thus, while ensuring the formation of the narrow gradation region 13, the processing difficulty is reduced, and the high mechanical strength of the shell 100 is also ensured. Further, the mass content of aluminum oxide in the second ceramic powder is 5%-10%. Specifically, the mass content of aluminum oxide in the second ceramic powder may be, but is not limited to, 2%, 5%, 7%, 9%, 12%, 15% or 18%.

In another embodiment of the present disclosure, the first ceramic powder further includes aluminum oxide, the mass content of aluminum oxide is less than or equal to 20%. Thus, it cannot only hinder the diffusion of the colorant, but also not affect the performance of the ceramic substrate 10 and the shell 100, which is conducive to obtaining an extremely narrow gradation region 13. Further, the mass content of aluminum oxide in the first ceramic powder is 3%-20%. Furthermore, the mass content of aluminum oxide in the first ceramic powder is 5%-10%. Specifically, the mass content of aluminum oxide in the first ceramic powder may be, but is not limited to, 2%, 5%, 7%, 9%, 12%, 15% or 18%.

In another embodiment of the present disclosure, the second ceramic powder further includes a second colorant. In an embodiment, the mass content of the second colorant in the second ceramic powder is less than or equal to 10%. Thus, the second ceramic green body prepared subsequently can present obvious color, and the shrinkage rates of ceramic green bodies are small during sintering, so as to avoid adverse effects on the performance of the ceramic substrate 10 and the shell 100. Further, the mass content of the second colorant in the second ceramic powder is 0.5%-8%. Furthermore, the mass content of the second colorant in the second ceramic powder is 1%-5%. In an embodiment of the present disclosure, the second colorant may be a spinel colorant, a non-spinel colorant, or a mixture of both. In another embodiment of the present disclosure, the second ceramic powder does not contain colorant. In a specific embodiment, the second colorant includes a spinel colorant or does not contain the second colorant. In this situation, it is conducive to the generation of a narrow gradation region 13 and the presentation of clearer color contrast lines. In an embodiment of the present disclosure, the content difference between the first colorant and the second colorant is greater than 2%. Further, the content difference between the first colorant and the second colorant is greater than 4%, further improving the color contrast effect. It may be understood that by controlling the content and color of the first colorant and the second colorant, the first ceramic green body and the second ceramic green body prepared subsequently have color difference.

In an embodiment of the present disclosure, after pre-pressing, the first ceramic raw material is made into the first ceramic green body, and the second ceramic raw material is made into the second ceramic green body. The pre-pressing includes processing at 5 MPa-20 MPa. By pre-pressing, the first ceramic raw material is made into the first ceramic green body, and the second ceramic raw material is made into the second ceramic green body. Further, the pre-pressing includes processing at 8 MPa-17 MPa.

In an embodiment of the present disclosure, after pre-pressing, densities of the first ceramic green body and the second ceramic green body each are 2.2 g/cm³-2.5 g/cm³ respectively. In another embodiment of the present disclosure, after pre-pressing, a density difference between the first ceramic green body and the second ceramic green body is less than 0.2 g/cm³. Further, after pre-pressing, the density difference between the first ceramic green body and the second ceramic green body is less than 0.15 g/cm³. Thus, it ensures that the density of the first ceramic green body and the second ceramic green body is similar. In the subsequent preparation process, the shrinkage rates of the green bodies are similar, making the straightness of an upper boundary of the ceramic substrate 10 better. In still another embodiment of the present disclosure, after pre-pressing, the Vickers hardness of the first ceramic green body and the second ceramic green body each are 10HV0.1-70HV0.1, so that each ceramic green body can maintain its original shape without deformation and distortion in the process of pre-pressing; and meanwhile, it will not make the ceramic green body too hard, avoiding more defects during the sintering process and the problem of low bonding strength between the ceramic green bodies. Further, the Vickers hardness of the first ceramic green body and the second ceramic green body each are 20HV0.1-40HV0.1. Furthermore, the Vickers hardness of the first ceramic green body and the second ceramic green body each are 25HV0.1-35 HV0.1. Thus, the bonding strength of the ceramic substrate 10 and the shell 100 is further improved.

In an embodiment of the present disclosure, the first ceramic green body and the second ceramic green body are spliced to form the ceramic substrate green body through final pressing and isostatic pressing. The final pressing includes processing at 50 MPa-80 MPa, and the isostatic pressing includes processing at 100 MPa-200 MPa. Through the final pressing and the isostatic pressing, the first ceramic green body and the second ceramic green body are more closely bonded, and densities of the first ceramic green body and the second ceramic green body are more similar, which is conducive to the sintering process, and better straightness of the first boundary line 14 and the second boundary line 15 is obtained. Further, the final pressing includes processing at 55 MPa-75 MPa, and the isostatic pressing includes processing at 120 MPa-190 MPa. Furthermore, the final pressing includes processing at 60 MPa-73 MPa, and the isostatic pressing includes processing at 150 MPa-180 MPa. Thus, the splicing between the first ceramic green body and the second ceramic green body in the ceramic green body assembly may be further improved without deformation to ensure that boundary lines with better straightness may be formed after the colorant is diffused during sintering.

In an embodiment of the present disclosure, a density difference between the first ceramic green body and the second ceramic green body after the final pressing is less than 0.15 g/cm³, a density of the ceramic substrate green body after the final pressing is greater than 3 g/cm³, and a straightness of a splicing line between the first ceramic green body and the second ceramic green body is less than 0.1 mm. Thus, the shrinkage rates of green bodies are similar, and the straightness of the upper boundary line of the shell 100 is better.

In an embodiment of the present disclosure, the density of the ceramic substrate green body after the isostatic pressing is greater than 3.1 g/cm³, and the straightness of the first ceramic green body and the second ceramic green body is less than 0.15 mm. Thus, the shrinkage rates of green bodies are similar in the subsequent preparation process, and the straightness of the upper boundary line of the shell 100 is better. In another embodiment, the isostatic pressing includes processing at 20°C-90°C, 100 MPa-200 MPa. Further, the density difference between the first ceramic green body and the second ceramic green body after the isostatic pressing is less than 0.05 g/cm³. In the present disclosure, the duration of the pre-pressing, the final pressing and the isostatic pressing is set according to the required density and density difference of the ceramic green body.

In the present disclosure, the first ceramic green body and the second ceramic green body may be spliced left and right, or spliced up and down, or arranged one around the other. and the specific location relationship may be selected according to actual needs. In addition, the above left-right splicing, up-down splicing are the relative position relationship between the first ceramic green body and the second ceramic green body in actual use, and are only for describing the exemplary arrangement of the first ceramic green body and the second ceramic green body. In the present disclosure, through the above forming method, it is possible to produce ceramic substrate green bodies of different shapes, such as, but not limited to, planar, three-dimensional, arced, and unequal thickness ceramic substrate green bodies, or circular, semicircular, elliptical, triangular, square, rectangular, and irregular polygon ceramic substrate green bodies, so as to improve the diversity of the shell 100.

FIG. 8 illustrates a schematic structural diagram of the ceramic substrate green body according to an embodiment of the present disclosure. In FIG. 8, (a)-(i) are schematic structural diagrams of the ceramic substrate green body with different splicing methods, A is a ceramic substrate green body presenting color A, B is a ceramic substrate green body presenting color B, and C is a ceramic substrate green body presenting color C. It may be understood that the ceramic substrate green body may be composed of, but not limited to, two, three or more kinds of ceramic green body bodies. By splicing multiple ceramic green bodies, and the adjacent ceramic green bodies have different colors, the ceramic substrate green body is formed, thereby improving the product diversity of the shell 100. It may be understood that FIG. 8 is a schematic diagram of an exemplary splicing method. In the actual preparation, the ceramic green body may be, but are not limited to, square, rectangle, irregular polygon, etc. In addition, two, three, or more ceramic green bodies may be spliced together, which may be selected according to actual needs.

In the block 103, the performing glue discharge includes processing at 300°C-500°C for 12 hours-24 hours, and the sintering includes processing at 1300°C-1500°C for 2h-4h. Specifically, the temperature of the glue discharge may be but not limited to 300°C, 320°C, 350°C, 370°C, 410°C, 450°C, 480°C or 500°C, and the duration of the glue discharge may be but not limited to 12 h, 14 hours, 15 hours, 17 hours, 19 hours, 20 hours, 22 hours or 24 hours, so as to ensure that the ceramic substrate green body will not crack during the glue discharge process. The sintering temperature may be but not limited to 1300°C, 1350°C, 1370°C, 1400°C, 1450°C, 1460°C or 1500°C, and the sintering duration may be but not limited to 2 hours, 2.5 hours, 3 hours, 3.5 hours or 4 hours to ensure the improvement of the internal bonding strength and compactness of the ceramic substrate green body. Through the glue discharge and the sintering, the organic components in the ceramic substrate green body, such as the first organic auxiliary agent and the second organic auxiliary agent, are discharged, and the compactness and bonding strength inside the ceramic substrate green body are enhanced. In this process, the first colorant and the second colorant diffuse, forming the gradation region 13, and obtaining a shell 100 with rich appearance effects. In an embodiment, the thermal diffusion temperature of the first colorant and the second colorant is lower than the sintering temperature. In an embodiment, the thermal diffusion temperature of the first colorant and the second colorant is lower than 1300°C. Further, the thermal diffusion temperature of the first colorant and the second colorant is lower than 1200°C. In another embodiment, a gas porosity of the ceramic substrate 10 is less than 1%, which enhances the overall mechanical properties. In another embodiment, after sintering, a difference of the gas porosity between the first ceramic green body and the second ceramic green body is less than 0.1%, thereby ensuring the overall performance of the shell 100. In still another embodiment, after sintering, the bonding strength of the first ceramic green body and the second ceramic green body is greater than 800 MPa. Further, the bonding strength of the first ceramic green body and the second ceramic green body is greater than 900 MPa. Thus, the internal bonding strength of the ceramic substrate 10 and the shell 100 is improved, so that it is not easy to crack.

In an embodiment of the present disclosure, the surface of the sintered ceramic substrate 10 is polished. In an embodiment, a polishing depth is greater than 0.05 mm. Thus, it is ensured that the color of the ceramic surface is consistent with that of the interior. Further, the surface of the ceramic substrate 10 is subjected to rough machining and finish machining to reduce the surface roughness, which is more conducive to its application. In a specific embodiment, the surface roughness of the sintered ceramic substrate 10 after sintering is less than 10.0 µm, the surface roughness of the polished ceramic substrate 10 after sintering is less than 1.0 µm, the surface roughness of the rough machined ceramic substrate 10 after sintering is less than 0.1 µm, the surface roughness of the finish machined ceramic substrate 10 after sintering is less than 0.01 µm. It has excellent smoothness and can be used for a rear cover, a frame, a key, a decorative piece and the like to improve the appearance effect of the products. In another specific embodiment, rough and fine trimming is performed on the surface of the ceramic substrate 10 by means of steel-plated carborundum, the rotating speed of the main shaft is 20000 revolutions per minute (rpm), and the power is 15 kilowatts (kW); and then, by means of polishing, the ceramic substrate 10 is placed in the diamond powder grinding fluid, the polishing pressure is 0.08 MPa-0.12 MPa, the rotating speed is 30 rpm-50 rpm, and the ceramic substrate 10 having a surface roughness of less than 0.01 µm is obtained.

The preparation method of the shell 100 according to the present disclosure is simple in operation, easy to mass produce, and can produce the shell 100 with rich appearance effects, which is beneficial to its application.

The present disclosure also provides an electronic device, including a shell 100 of any of the above embodiments. Understandably, the electronic device may be but are not limited to a mobile phone, a tablet, a laptop, a watch, an MP3, an MP4, a global positioning system (GPS) navigator, a digital camera, etc. In an embodiment of the present disclosure, the electronic device includes a shell and a main board, and the shell includes the shell 100 of any of the above embodiments. The shell 100 can give the electronic device a variety of color appearances, and also has a color gradation region 13. The straightness of the boundary lines between the regions is good, and the expressiveness of the electronic device is improved.

### Embodiment 1

4% of cobalt aluminate (particle size of 800 nm), 2% of aluminum oxide (600 nm in particle size), 2% of hafnium oxide, 5% of yttrium oxide, and a balance of zirconium oxide (particle size of 280 nm) are weighed in percentage by mass to obtain ceramic powder. The ceramic powder is mixed with an organic auxiliary agent to obtain a ceramic slurry, in which the organic auxiliary agent accounts for 6% of the mass of the ceramic powder, and a binder in the organic auxiliary agent accounts for 4% of the mass of the ceramic powder. After the ceramic slurry is subjected to spray granulation, a ceramic raw material is obtained, the median particle size D50 of the ceramic raw material is 70 µm, the apparent density is 1.6 g/cm³, and the ceramic raw material is pre-pressed at 12 MPa to obtain a blue ceramic green body A with a density of 2.3 g/cm³ and a hardness of 25HV0.1.

5% of (Co_{0.7}Zn_{0.3})(Fe_{0.7}Al_{0.3})₂O₄ (particle size 950 nm), 0.5% of aluminum oxide (particle size 600 nm), 2% of hafnium oxide, 5% of yttrium oxide and a balance of zirconia (particle size 28 0nm) are weighed in percentage by mass to obtain ceramic powder. The ceramic powder is mixed with an organic auxiliary agent to obtain a ceramic slurry, in which the organic auxiliary agent accounts for 8% of the mass of the ceramic powder and a binder in the organic auxiliary agent accounts for 6% of the mass of the ceramic powder. After the ceramic slurry is subjected to spray granulation, a ceramic raw material is obtained, and the median particle size D50 of the ceramic raw material is 80 µm, and the apparent density is 1.5 g/cm³. The ceramic raw material is pre-pressed at 16 MPa to obtain a black ceramic green body B with a density of 2.2 g/cm³ and a hardness of 20HV0.1.

3% of chromium oxide (particle size 700 nm), 1.5% of aluminum oxide (particle size 600nm), 2% of hafnium oxide, 5% of yttrium oxide and a balance of zirconia (particle size 280 nm) are weighed in percentage by mass to obtain ceramic powder. The ceramic powder is mixed with an organic auxiliary agent to obtain a ceramic slurry, in which the organic auxiliary agent accounts for 7% of the mass of the ceramic powder and a binder accounts for 5% of the mass of the ceramic powder in the organic auxiliary agent. After the ceramic slurry is subjected to spray granulation, a ceramic raw material is obtained, and the median particle size D50 of the ceramic raw material is 90 µm, and the apparent density is 1.4g/cm³. The ceramic raw material is pre-pressed at 20 MPa to obtain a green ceramic green body C with a density of 2.3g/cm³ and a hardness of 28HV0.1.

The ceramic green body A, the ceramic green body B and the ceramic green body C have a length of 160 mm, a width of 70 mm and a thickness of 1 mm. When the ceramic green bodies are spliced, one of the ceramic green bodies is disposed on one side of the other ceramic green body of the ceramic green bodies, so that a boundary line with a length of 160 mm can be displayed in the final shell.

The ceramic green body A and the ceramic green body B are spliced and subject to final pressing under the pressure of 80 MPa. The straightness of a splicing line between the ceramic green body A and the ceramic green body B is 0.08 mm, the density of the ceramic green body A after the final pressing is 3.05 g/cm³, and the density of the ceramic green body B after the final pressing is 3.1 g/cm³. After isostatic pressing treatment at 80°C and 180 MPa, the straightness of the splicing line between the ceramic green body A and the ceramic green body B is 0.13 mm, the density of the ceramic green body A after the isostatic pressing is 3.17 g/cm³, and the density of ceramic green body B after the isostatic pressing is 3.19 g/cm³. After discharging glue at 450°C for 20 hours and sintering at 1450°C for 2 hours, a shell A/B is obtained, with a density of 6.03 g/cm³ and a bonding strength of 951 MPa, the straightness of a boundary line between the blue region and the gradation region is 0.3 mm, and the straightness of a boundary line between the black region and the gradation region is 0.3 mm.

The ceramic green body A and the ceramic green body C are spliced and subject to final pressing under the pressure of 70 MPa. The straightness of a splicing line between the ceramic green body A and the ceramic green body C is 0.06 mm, the density of the ceramic green body A after the final pressing is 3.02 g/cm³, and the density of the ceramic green body C after the final pressing is 3.06 g/cm³. After isostatic pressing treatment at 70°C and 190 MPa, the straightness of the splicing line between the ceramic green body A and the ceramic green body C is 0.09 mm, the density of the ceramic green body A after the isostatic pressing is 3.14 g/cm³, and the density of ceramic green body C is 3.17 g/cm³. After discharging glue at 450°C for 20 hours and sintering at 1430°C for 2 hours, a shell A/C is obtained, with a density of 6.05g/cm3 and a bonding strength of 927MPa, the straightness of a boundary line between the blue region and the gradation region is 0.15 mm, and the straightness of a boundary line between the green region and the gradation region is 0.15 mm.

The ceramic green body B and the ceramic green body C are spliced and subject to final pressing under the pressure of 50 MPa. The straightness of a splicing line between the ceramic green body B and the ceramic green body C is 0.09 mm, the density of the ceramic green body B after the final pressing is 3.01 g/cm³, and the density of the ceramic green body C is 3.08 g/cm³. After isostatic pressing treatment at 20°C and 180 MPa, the straightness of the splicing line between the ceramic green body B and the ceramic green body C is 0.12 mm, the density of the ceramic green body B after the isostatic pressing is 3.11 g/cm³, and the density of the ceramic green body C after the isostatic pressing is 3.18g/cm³. After discharging glue at 500°C for 20 hours and sintering at 1470°C for 2 hours, a shell B/C is obtained, with a density of 6.01g/cm³ and a bonding strength of 937 MPa, the straightness of a boundary line between the blue region and the gradation region is 0.45 mm, and the straightness of a boundary line between the green region and the gradation region is 0.45 mm.

### Embodiment 2

5% of cobalt aluminate (particle size 1000 nm), 1% of hafnium oxide, 6% of yttrium oxide and a balance of zirconia (particle size 300 nm) are weighed in percentage by mass to obtain ceramic powder. The ceramic powder is mixed with an organic auxiliary agent to obtain a ceramic slurry, in which the organic auxiliary agent accounts for 5% of the mass of the ceramic powder and a binder in the organic auxiliary agent accounts for 3.5% of the mass of the organic auxiliary agent. After the ceramic slurry is subjected to spray granulation, a ceramic green body D is obtained by pre-pressing.

7% of chromium oxide (particle size 1000 nm), 2% of hafnium oxide, 5% of yttrium oxide and a balance of zirconia (particle size 400 nm) are weighed in percentage by mass to obtain ceramic powder. The ceramic powder is mixed with an organic auxiliary agent to obtain a ceramic slurry, in which the organic auxiliary agent accounts for 7% of the mass of the ceramic powder and a binder in the organic auxiliary agent accounts for 5% of the mass of the ceramic powder. After the ceramic slurry is subjected to spray granulation, a ceramic green body E is obtained by pre-pressing.

After the pre-pressed ceramic green body D and the pre-pressed ceramic green body E with different density differences are subject to final pressing and isostatic pressing, multiple groups of ceramic substrate green bodies, and then multiple groups of shells D/E are obtained through glue discharge and sintering, and the bonding strength of the multiple groups of shells D/E, the straightness of a boundary line between the blue region and the gradation region, and the straightness of a boundary line between the green region and the gradation region are detected, and results are shown in Table 1.

**Table 1 Parameters of multiple groups of shells D/E prepared in embodiment 2**

| | First group | Second group | Third group | Fourth group | Fifth group | Sixth group | Seventh group |
|---|---|---|---|---|---|---|---|
| Density difference after pre-pressing (g/cm³) | 0.14 | 0.18 | 0.14 | 0.14 | 0.24 | 0.14 | 0.14 |
| Hardness of ceramic green bodies D and E after pre-pressing (HV0.1) | 20-25 | 20-25 | 60-65 | 10-15 | 20-25 | 5-9 | 75-80 |
| Density difference after final pressing (g/cm³) | 0.08 | 0.13 | 0.08 | 0.08 | 1.4 | 0.08 | 0.08 |
| Density difference after isostatic pressing (g/cm³) | 0.03 | 0.07 | 0.03 | 0.03 | 1.0 | 0.03 | 0.03 |
| Straightness (mm) | 0.26 | 0.32 | 0.21 | 0.47 | 0.63 | 0.67 | 0.19 |
| Bonding strength (MPa) | 920 | 912 | 835 | 943 | 925 | 923 | 727 |

It can be seen from the embodiment of the present disclosure that when the density difference between the ceramic green bodies in the ceramic substrate green body is greater than 0.08 g/cm³ or the hardness of the ceramic green body is less than 10HV0.1, the straightness of the boundary lines between the regions in the shell cannot be less than 0.5 mm, thus affecting the appearance effect of the shell. Compared with the other groups, the hardness of the ceramic green body in the seventh group is higher, which has a slight impact on the bonding strength between the two ceramic green bodies in the subsequent splicing process. In addition, by controlling the density difference between the ceramic green bodies after the isostatic pressing, the boundary lines between the various color regions in the shell can be more orderly.

### Embodiment 3

2% of hafnium oxide, 5% of yttrium oxide and 93% of zirconia are weighed in percentage by mass and mixed with a binder, and a ceramic green body F-1 with a hardness of 30HV0.1 is obtained after dry pressing molding.

0.5% of Er₂O₃ colorant, 0.3% of aluminum oxide, 2% of hafnium oxide, 5% of yttrium oxide and a balance of zirconia are weighed in percentage by mass and mixed with a binder, a dispersant, and a lubricant, and a ceramic green body F-2 with a hardness of 30HV0.1 is obtained after dry press molding.

1.5% of Er₂O₃ colorant, 0.6% of aluminum oxide, 2% of hafnium oxide, 5% of yttrium oxide and a balance of zirconia are weighed in percentage by mass and mixed with a binder, a dispersant, and a lubricant, and a ceramic green body F-3 with a hardness of 30HV0.1 is obtained after dry press molding.

3% of Er₂O₃ colorant, 0.6% of aluminum oxide, 2% of hafnium oxide, 5% of yttrium oxide and a balance of zirconia are weighed in percentage by mass and mixed with an organic auxiliary agent, and a ceramic green body F-4 with a hardness of 28HV0.1 is obtained after dry press molding.

1.5% of aluminum oxide, 2% of hafnium oxide, 5% of yttrium oxide and a balance of zirconia are weighed in percentage by mass and mixed with an auxiliary agent, and a ceramic green body F-5 with a hardness of 25HV0.1 is obtained after dry pressing molding.

In an embodiment, the above Er₂O₃ colorant has a non-spinel structure with a particle size of 900 nm.

7% of Cr₂O₃ colorant, 0.5% of aluminum oxide, 2% of hafnium oxide, 5% of yttrium oxide and a balance of zirconia are weighed in percentage by mass and mixed with a binder, and a ceramic green body G-1 with a hardness of 28HV0.1 is obtained after dry pressing molding.

5% of Cr₂O₃ colorant, 0.2% of aluminum oxide, 2% of hafnium oxide, 5% of yttrium oxide and a balance of zirconia are weighed in percentage by mass and mixed with a binder, a defoamer, and a dispersant, and a ceramic green body G-2 with a hardness of 25HV0.1 is obtained after dry pressing molding.

3% of Cr₂O₃ colorant, 0.6% of aluminum oxide, 2% of hafnium oxide, 5% of yttrium oxide and a balance of zirconia are weighed in percentage by mass and mixed with an organic auxiliary agent, and a ceramic green body G-3 with a hardness of 30HV0.1 is obtained after dry pressing molding.

In an embodiment, the above Cr₂O₃ colorant has a non-spinel structure with a particle size of 600 nm.

7% of Cr₂O₃ of colorant (non-spinel structure, particle size 80 nm), 0.5% of aluminum oxide, 2% of hafnium oxide, 5% of yttrium oxide and a balance of zirconia are weighed in percentage by mass and mixed with an organic auxiliary agent, and a ceramic green body G-4 with a hardness of 26HV0.1 is obtained after dry pressing molding.

7% of Cr₂O₃ colorant (non-spinel structure, particle size 2500 nm), 0.5% of aluminum oxide, 2% of hafnium oxide, 5% of yttrium oxide and a balance of zirconia are weighed in percentage by mass and mixed with an organic auxiliary agent, and a ceramic green body G-5 with a hardness of 30HV0.1 is obtained after dry pressing molding.

7% of CoAl₂O₄ colorant (spinel structure, particle size 1200 nm), 0.5% of aluminum oxide, 2% of hafnium oxide, 5% of yttrium oxide and a balance of zirconia are weighed in percentage by mass and mixed with a binder, a defoamer and a dispersant, and a ceramic green body H-1 with a hardness of 30HV0.1 is obtained after dry pressing molding.

1.5% of (Co_{0.7}Zn_{0.3})(Fe_{0.7}Al_{0.3})₂O₄ colorant (spinel structure, particle size 1200 nm), 0.6% of aluminum oxide, 2% of hafnium oxide, 5% of yttrium oxide and a balance of zirconia are weighed in percentage by mass and mixed with a binder, a defoamer and a dispersant, and a ceramic green body I-1 with a hardness of 30 HV0.1 is obtained after dry pressing molding.

0.5% of Cr₂O₃ colorant (non-spinel structure, particle size of 600 nm), 0.5% of CoAl₂O₄ colorant (spinel structure, particle size of 1200 nm), 0.6% of aluminum oxide, 2% of hafnium oxide, 5% of yttrium oxide and a balance of zirconia are weighed in percentage by mass and mixed with an organic auxiliary agent, and a ceramic green body J-1 with a hardness of 30HV0.1 after dry pressing molding.

The ceramic green bodies prepared above are spliced according to the combination manner shown in Table 1, final pressing is performed at 75 MPa, and then isostatic pressing treatment is performed at 60°C and 180 MPa to form ceramic substrate green bodies, in which the density difference of adjacent ceramic green bodies is less than 0.08 g/cm³. After the ceramic substrate green bodies are treated at 400°C for 15 hours, and then at 1400 °C for 4 hours, the shells are obtained. On the shell surface, there is an obvious and clear boundary between adjacent color regions, and the straightness of the boundary line is less than 0.45 mm.

In addition, a width of the gradation region of the prepared shell is measured, and results are shown in Table 2. The width of the gradation region is measured by determining the boundary lines between the gradation region and the first region and the second region, measuring a distance between the two boundary lines with a vernier caliper, measuring three different positions on each boundary line and calculating the average value.

**Table 2 Width of gradation region of multiple groups of shells prepared in embodiment 3**

| Combination manner | Width of gradation region (mm) |
|---|---|
| F-1/G-1 | 15.5 |
| F-1/G-2 | 8.0 |
| F-1/G-3 | 4.5 |
| F-2/G-1 | 12.0 |
| F-3/G-1 | 6.0 |
| F-4/G-1 | 3.5 |
| F-5/G-1 | 4 |
| F-3/G-3 | 1.5 |
| F-1/H-1 | 6.0 |
| F-2/H-1 | 6.0 |
| H-1/1-1 | 1.0 |
| G-1/J-1 | 6.8 |
| F-1/G-4 | 18.4 |
| F-1/G-5 | 11.0 |
| F-1/G-1/H-1 (Combined in the manner shown in (g) in FIG. 3) | 14.8 between F-1/G-1 |
| | 6.4 between F-1/H-1 |
| | 1.4 between G-1/H-1 |

It can be seen from the results of the embodiment of the present disclosure that the colorant content in the ceramic green body F-4 exceeds 2%, and the colorant content in the ceramic green body G-3 is less than 4%, thus making the width of the gradation region of the shell F-4/G-1, the shell F-1/G-3, and the shell F-3/G-3 less than 5 mm. Both the ceramic green body H-1 and the ceramic green body I-1 both contain the spinel colorant, so that the width of gradation region of the shell H-1/I-1 is far less than 5 mm. The content of aluminum oxide in the ceramic green body F-5 is too high, which makes the width of gradation region in the shell F-5/G-1 narrower than that in the shell F-1/G-1. Compared with the ceramic green bodies G-2 and G-3, the ceramic green body G-1 has a higher content of colorant, and thus has a wider range of gradation region with the shell formed by the ceramic green body F-1. The mechanical properties of the shell F-1/G-1 are superior to those of the shell F-1/G-4 because of the smaller particle size of colorant used in the ceramic green body G-4. The color uniformity of the shell F-1/G-1 is better than that of the shell F-1/G-5 due to the large particle size of colorant used in the ceramic green body G-5. Since the ceramic green body G-1 contains a colorant with a non-spinel structure, and the ceramic green body H-1 contains a colorant with a spinel structure, the width of the gradation region of the shell F-1/G-1 is obviously larger than that of the F-1/H-1.

### Embodiment 4

4% of (Co_{0.7}Zn_{0.3})(Fe_{0.7}Al_{0.3})₂O₄ colorant, 7% of aluminum oxide, 2% of hafnium oxide, 5% of yttrium oxide and a balance of zirconia are weighed in percentage by mass and mixed with a binder, and a ceramic green body K-1 with a hardness of 35HV0.1 is obtained after dry pressing molding.

9% of (Co_{0.7}Zn_{0.3})(Fe_{0.7}Al_{0.3})₂O₄ colorant, 7% of aluminum oxide, 2% of hafnium oxide, 5% of yttrium oxide and a balance of zirconia are weighed in percentage by mass and mixed with a binder, a dispersant and a lubricant, and a ceramic green body K-2 with a hardness of 36HV0.1 is obtained after dry pressing molding.

15% of (Co_{0.7}Zn_{0.3})(Fe_{0.7}Al_{0.3})₂O₄ colorant, 7% of aluminum oxide, 2% of hafnium oxide, 5% of yttrium oxide and a balance of zirconia are weighed in percentage by mass and mixed with an organic auxiliary agent, and a ceramic green body K-3 with a hardness of 33HV0.1 is obtained after dry pressing molding.

4% of (Co_{0.7}Zn_{0.3})(Fe_{0.7}Al_{0.3})₂O₄ colorant, 2% of hafnium oxide, 5% of yttrium oxide and a balance of zirconia are weighed in percentage by mass and mixed with an organic auxiliary agent, and a ceramic green body K-4 with a hardness of 35HV0.1 is obtained after dry pressing molding.

4% of (Co_{0.7}Zn_{0.3})(Fe_{0.7}Al_{0.3})₂O₄ colorant, 3% of aluminum oxide, 2% of hafnium oxide, 5% of yttrium oxide and a balance of zirconia are weighed in percentage by mass and mixed with an organic auxiliary agent, and a ceramic green body K-5 with a hardness of 36HV0.1 is obtained after dry pressing molding.

4% of (Co_{0.7}Zn_{0.3})(Fe_{0.7}Al_{0.3})₂O₄ colorant, 7% of aluminum oxide, 2% of hafnium oxide, 5% of yttrium oxide and a balance of zirconia are weighed in percentage by mass and mixed with an organic auxiliary agent, and a ceramic green body K-6 with a hardness of 36HV0.1 is obtained after dry pressing molding.

4% of (Co_{0.7}Zn_{0.3})(Fe_{0.7}Al_{0.3})₂O₄ colorant, 7% of aluminum oxide, 2% of hafnium oxide, 5% of yttrium oxide and a balance of zirconia are weighed in percentage by mass and mixed with an organic auxiliary agent, and a ceramic green body K-7 with a hardness of 35HV0.1 is obtained after dry pressing molding.

4% of (Co_{0.7}Zn_{0.3}) (Fe_{0.7}Al_{0.3})₂O₄ colorant, 7% of aluminum oxide, 2% of hafnium oxide, 5% of yttrium oxide and a balance of zirconia are weighed in percentage by mass and mixed with an organic auxiliary agent, and a ceramic green body K-8 with a hardness of 35HV0.1 is obtained after dry pressing molding.

4% of (Co_{0.7}Zn_{0.3})(Fe_{0.7}Al_{0.3})₂O₄ colorant, 7% of aluminum oxide, 2% of hafnium oxide, 5% of yttrium oxide and a balance of zirconia are weighed in percentage by mass and mixed with an organic auxiliary agent, and a ceramic green body K-9 with a hardness of 34HV0.1 is obtained after dry pressing molding.

4% of Cr₂O₃ colorant, 2% of aluminum oxide, 2% of hafnium oxide, 5% of yttrium oxide and a balance of zirconia are weighed in percentage by mass and mixed with an organic auxiliary agent, and a ceramic green body L-1 with a hardness of 36HV0.1 is obtained after dry pressing molding.

4% of Cr₂O₃ colorant, 7% of aluminum oxide, 2% of hafnium oxide, 5% of yttrium oxide and a balance of zirconia are weighed in percentage by mass and mixed with an organic auxiliary agent, and a ceramic green body L-2 with a hardness of 35HV0.1 is obtained after dry pressing molding.

2% of aluminum oxide, 2% of hafnium oxide, 5% of yttrium oxide and a balance of zirconia are weighed in percentage by mass and mixed with an organic auxiliary agent, and a ceramic green body M-1 with a hardness of 35HV0.1 is obtained after dry pressing molding.

7% of aluminum oxide, 2% of hafnium oxide, 5% of yttrium oxide and a balance of zirconia are weighed in percentage by mass and mixed with an organic auxiliary agent, and a ceramic green body M-2 with a hardness of 34HV0.1 is obtained after dry pressing molding.

25% of aluminum oxide, 2% of hafnium oxide, 5% of yttrium oxide and a balance of zirconia are weighed in percentage by mass and mixed with an organic auxiliary agent, and a ceramic green body M-3 with a hardness of 36HV0.1 is obtained after dry pressing molding.

2% of CoAl₂O₄ colorant, 2% of Cr₂O₃ colorant, 2% of aluminum oxide, 2% of hafnium oxide, 5% of yttrium oxide and a balance of zirconia are weighed in percentage by mass and mixed with a binder, and a ceramic green body N-1 with a hardness of 35HV0.1 is obtained after dry pressing molding.

2% of CoAl₂O₄ colorant, 2% of Cr₂O₃ colorant, 7% of aluminum oxide, 2% of hafnium oxide, 5% of yttrium oxide and a balance of zirconia are weighed in percentage by mass and mixed with a binder, a dispersant and a lubricant, and ceramic green body N-2 with a hardness of 35HV0.1 is obtained after dry pressing molding.

Specifically, the above (Co_{0.7}Zn_{0.3})(Fe_{0.7}Al_{0.3})₂O₄ colorant and the above CoAl₂O₄ colorant are spinel colorants, and the Cr₂O₃ colorant is a non-spinel colorant. The particle size of colorant in the ceramic green body K-6 is 50 nm, the particle size of colorant in the ceramic green body K-7 is 2500 nm, the particle size of other (Co_{0.7}Zn_{0.3})(Fe_{0.7}Al_{0.3})₂O₄ colorants is 800 nm, and the particle size of Cr₂O₃ colorant is 600 nm. The particle size of aluminum oxide in the ceramic green body K-8 is 60 nm, the particle size of aluminum oxide in the ceramic green body K-9 is 2200 nm, and the particle size of aluminum oxide in other ceramic green bodies is 300 nm.

The ceramic green body green bodies prepared above are spliced according to the combination manner shown in Table 3, final pressing is performed at 70 MPa, and then isostatic pressing treatment is performed at 60°C and 150 MPa to form ceramic substrate green bodies, in which the density difference of adjacent ceramic green bodies is less than 0.08 g/cm³. After the ceramic substrate green bodies are treated at 380°C for 20 hours, and then at 1450 °C for 3.5 hours, the shells are obtained. On the shell surface, there is an obvious and clear boundary between adjacent color regions, and the straightness of the boundary line is less than 0.5 mm.

In addition, a width of the gradation region of the prepared shell is measured, and results are shown in Table 3. The width of the gradation region is measured by placing it under an optical microscope, enlarging it to an appropriate multiple, determining the boundary lines between the gradation region and the first region and the second region, measuring a distance between the two boundary lines, measuring three different positions on each boundary line, calculating the average value.

**Table 3 Width of gradation region of multiple groups of shells prepared in embodiment 4**

| Combination manner | Width of gradation region (mm) | Combination manner | Width of gradation region (mm) |
|---|---|---|---|
| K-1/M-1 | 96 | K-1/M-2 | 82 |
| K-1/M-3 | 63 | | |
| K-2/M-1 | 136 | K-2/M-2 | 102 |
| K-3/M-1 | 221 | K-3/M-2 | 207 |
| K-4/M-1 | 172 | K-4/M-2 | 135 |
| K-5/M-1 | 155 | K-5/M-2 | 137 |
| K-6/M-1 | 112 | K-7/M-1 | 74 |
| K-8/M-1 | 190 | K-9/M-1 | 67 |
| K-2/L-1 | 368 | K-1/L-1 | 287 |
| K-2/L-2 | 180 | K-1/L-2 | 164 |
| K-1/N-1 | 167 | K-1/N-2 | 134 |
| M-1/K-1/L-1 | 157 between K-1/L-1 | | |
| | 92 between K-1/M-1 | | |

It can be seen from the results of the embodiment of the present disclosure that the content of colorant in the ceramic green body K-3 exceeds 10%, and the content of aluminum oxide in the ceramic green body L-1 is less than 3%, thus making the width of the gradation region of the shells K-3/M-1, K-3/M-2, K-1/L-1, K-2/L-1 greater than 200 µm. The content of aluminum oxide in the ceramic green bodies M-1, M-2 and M-3 is sequentially increased, which makes the width of gradation region in the shells K-1/M-1, K-1/M-2 and K-1/M-3 decrease gradually, and the mechanical properties of the shell K-1/M-3 decrease slightly. Compared with the shell K-6/M-1, the colorant in the K-1/M-1 is not easy to agglomerate, and the obtained shell has better mechanical properties. Compared with the shell K-7/M-1, the shell K-1/M-1 has a more delicate appearance. Compared with the shell K-8/M-1, the gradation region of the shell K-1/M-1 has a narrower width, a more obvious color contrast effect, and lines in the gradation region are clearer. Compared with the shell K-9/M-1, the color distribution of the shell K-1/M-1 is uniform, and the obtained shell has better mechanical properties. The mechanical properties of the shell K-1/M-1 are inspected, it is found that the flexural strength of the shell K-1/M-1 is 850 MPa, the fracture toughness is greater than 7 MPa*m^{1/2}, the Vickers hardness is 600 Hv0.1, the gas porosity is less than 1%, and the surface roughness after processing is less than 0.01 µm.

The contents provided by the embodiments of the present disclosure are described in detail above, and the principles and embodiments of the present disclosure are described and explained herein, and the above description is only used to help understand the method and core idea of the present disclosure.

## Claims

1. A shell (100), comprising a ceramic substrate (10), wherein the ceramic substrate (10) comprises a first region (11), a second region (12) and a gradation region (13) located between the first region (11) and the second region (12);
the first region (11) presents a first color, the second region (12) presents a second color, and the first region (11) and the second region (12) have a color difference;
a direction from the first region (11) to the second region (12) is a first direction, and the gradation region (13) presents a gradation from the first color to the second color along the first direction; and
a surface of the ceramic substrate (10) is disposed with a first boundary line (14) and a second boundary line (15), the first boundary line (14) is located between the first region (11) and the gradation region (13), the second boundary line (15) is located between the second region (12) and the gradation region (13);
**characterized in that** a straightness of at least one of the first boundary line (14) and the second boundary line (15) is less than 0.5 mm, wherein the straightness is a maximum value of a vertical distance between a wave peak and a wave trough of a curve defined by the at least one of the first boundary line (14) and the second boundary line (15).

2. The shell (100) according to claim 1, wherein the straightness of at least one of the first boundary line (14) and the second boundary line (15) is less than 0.3 mm;
wherein the first boundary line (14) is parallel to the second boundary line (15); and
wherein a size of the gradation region (13) in the first direction is less than or equal to 20 mm.

3. The shell (100) according to claim 1, wherein the first region (11) comprises a first colorant, and a mass content of the first colorant in the first region (11) is in a range of 0.1% to 10%; the second region (12) comprises a second colorant, and a mass content of the second colorant in the second region (12) is less than or equal to 10%.

4. The shell (100) according to claim 3, wherein the mass content of the first colorant in the first region (11) is in a range of 4% to 10%, the mass content of the second colorant in the second region (12) is in a range of 0% to 2%, and at least one of the first colorant and the second colorant is a non-spinel colorant;
wherein a material of the ceramic substrate (10) comprises aluminum oxide, and a mass content of the aluminum oxide in the ceramic substrate (10) is less than 1%.

5. The shell (100) according to claim 3, wherein the first colorant is a spinel colorant, wherein the second region (12) comprises aluminum oxide, and a mass content of the aluminum oxide in the second region (12) is in a range of 3% to 20%;
wherein the first region (11) comprises aluminum oxide, and a mass content of the aluminum oxide in the first region (11) is less than or equal to 20%.

6. The shell (100) according to claim 1, wherein an optical transmittance of the second region (12) is greater than 40%;
wherein, by mass percentages, materials of the second region (12) comprise 0.2%-0.5% of aluminum oxide, 0.5%-1% of silicon dioxide, 2%-10% of stabilizer, and a balance of zirconia.

7. The shell (100) according to claim 1, further comprising a color layer (20) disposed on the surface of the ceramic substrate (10), wherein the color layer (20) covers the second region (12), and the color layer (20) has a color difference with the first region (11);
wherein an optical transmittance of the second region (12) is greater than 40%.

8. The shell (100) according to claim 1, wherein the first region (11) and the gradation region (13) are arranged adjacent to each other, and the second region (12) and the gradation region (13) are arranged adjacent to each other;
wherein a value of the color difference between the first region (11) and the second region (12) is greater than 2;
wherein a density of the ceramic substrate (10) is greater than 6 g/cm³, a flexural strength of the ceramic substrate (10) is greater than 800 MPa, a fracture toughness of the ceramic substrate (10) is greater than 7 MPa*m^{1/2}, a Vickers hardness of the ceramic substrate (10) is greater than 500HV0.1, and a surface roughness of the ceramic substrate (10) is less than 0.01µm.

9. A preparation method for a shell (100), **characterized by** comprising:
providing (101) a first ceramic green body and a second ceramic green body, wherein the first ceramic green body and the second ceramic green body have a color difference, and a Vickers hardness of each of the first ceramic green body and the second ceramic green body is greater than or equal to 10HV0.1;
splicing (102) the first ceramic green body and the second ceramic green body to obtain a spliced ceramic green body and then pressing the spliced ceramic green body to form a ceramic substrate green body, wherein a density difference between the first ceramic green body and the second ceramic green body in the ceramic substrate green body is less than 0.08 g/cm³; and
performing (103) glue discharging and sintering on the ceramic substrate green body to obtain a ceramic substrate (10), thereby obtaining the shell (100) as claimed in any one of claims 1-8.

10. The preparation method according to claim 9, wherein the providing a first ceramic green body and a second ceramic green body comprises:
providing a first ceramic raw material and a second ceramic raw material, wherein a difference between median particle diameters D50 of the first ceramic raw material and the second ceramic raw material is less than 30 µm, a difference between apparent densities of the first ceramic raw material and the second ceramic raw material is less than 0.2g/cm³;
after pre-pressing, making the first ceramic raw material into the first ceramic green body and making the second ceramic raw material into the second ceramic green body.

11. The preparation method according to claim 10, wherein the median particle size D50 of the first ceramic raw material is in a range of 50 µm to 100 µm, the apparent density of the first ceramic raw material is in a range of 1.2 g/cm³ to1.8 g/cm³; the median particle size D50 of the second ceramic raw material is in a range of 50 µm to 100 µm, and the apparent density of the second ceramic raw material is in a range of 1.2 g/cm³ to 1.8 g/cm³;
the pre-pressing comprises processing at a pressure in a range of 5 MPa to 20 MPa, a density of each of the first ceramic green body and the second ceramic green body is in a range of 2.2g/cm³ to 2.5g/cm³, a density difference between the first ceramic green body and the second ceramic green body is less than 0.2 g/cm³, and a Vickers hardness of each of the first ceramic green body and the second ceramic green body is in a range of 10HV0.1 to 70HV0.1.

12. The preparation method according to claim 9, wherein the splicing the first ceramic green body and the second ceramic green body to obtain a spliced ceramic green body and then pressing the spliced ceramic green body to form a ceramic substrate green body comprises:
splicing the first ceramic green body and the second ceramic green body to form the ceramic substrate green body by final pressing and isostatic pressing, wherein the final pressing comprises processing at a pressure in a range of 50 MPa to 80MPa, and the isostatic pressing comprises processing at a pressure in a range of 100 MPa to 200 MPa.

13. The preparation method according to claim 12, wherein a density difference between the first ceramic green body and the second ceramic green body after the final pressing is less than 0.15 g/cm³, a density of the ceramic substrate green body after the final pressing is greater than 3 g/cm³, and a density of the ceramic substrate green body after the isostatic pressing is greater than 3.1 g/cm³.

14. The preparation method according to claim 9, wherein the glue discharging comprises processing at a temperature in a range of 300°C to 500°C for 12 hours to 24 hours; and the sintering comprises processing at a temperature in a range of 1300°C to 1500°C for 2 hours to 4 hours.

15. An electronic device, comprising the shell (100) according to any one of claims 1 to 8 and a main board.

## Patentansprüche

1. Schale (100), umfassend ein Keramiksubstrat (10), wobei das Keramiksubstrat (10) eine erste Region (11), eine zweite Region (12) und eine Abstufungsregion (13), die sich zwischen der ersten Region (11) und der zweiten Region (12) befindet, umfasst;
wobei die erste Region (11) eine erste Farbe präsentiert, die zweite Region (12) eine zweite Farbe präsentiert und die erste Region (11) und die zweite Region (12) einen Farbunterschied aufweisen;
wobei eine Richtung von der ersten Region (11) zur zweiten Region (12) eine erste Richtung ist und wobei die Abstufungsregion (13) eine Abstufung von der ersten Farbe zur zweiten Farbe entlang der ersten Richtung präsentiert; und
wobei eine Oberfläche des Keramiksubstrats (10) mit einer ersten Begrenzungslinie (14) und einer zweiten Begrenzungslinie (15) angeordnet ist, wobei sich die erste Begrenzungslinie (14) zwischen der ersten Region (11) und der Abstufungsregion (13) befindet, wobei sich die zweite Begrenzungslinie (15) zwischen der zweiten Region (12) und der Abstufungsregion (13) befindet;
**dadurch gekennzeichnet, dass** eine Geradheit von zumindest einer aus der ersten Begrenzungslinie (14) und der zweiten Begrenzungslinie (15) kleiner als 0,5 mm ist, wobei die Geradheit ein maximaler Wert eines vertikalen Abstands zwischen einem Wellenberg und einem Wellental einer Kurve ist, die durch die zumindest eine aus der ersten Begrenzungslinie (14) und der zweiten Begrenzungslinie (15) definiert wird.

2. Schale (100) nach Anspruch 1, wobei die Geradheit von zumindest einer aus der ersten Begrenzungslinie (14) und der zweiten Begrenzungslinie (15) kleiner als 0,3 mm ist;
wobei die erste Begrenzungslinie (14) parallel zur zweiten Begrenzungslinie (15) ist; und
wobei eine Größe der Abstufungsregion (13) in der ersten Richtung kleiner als oder gleich 20 mm ist.

3. Schale (100) nach Anspruch 1, wobei die erste Region (11) ein erstes Farbmittel umfasst und ein Massengehalt des ersten Farbmittels in der ersten Region (11) in einem Bereich von 0,1 % bis 10 % ist; wobei die zweite Region (12) ein zweites Farbmittel umfasst und ein Massengehalt des zweiten Farbmittels in der zweiten Region (12) kleiner als oder gleich 10 % ist.

4. Schale (100) nach Anspruch 3, wobei der Massengehalt des ersten Farbmittels in der ersten Region (11) in einem Bereich von 4 % bis 10 % ist, der Massengehalt des zweiten Farbmittels in der zweiten Region (12) in einem Bereich von 0 % bis 2 % ist und zumindest eines aus dem ersten Farbmittel und dem zweiten Farbmittel ein Nicht-Spinell-Farbmittel ist;
wobei ein Material des Keramiksubstrats (10) Aluminiumoxid umfasst und ein Massengehalt des Aluminiumoxids im Keramiksubstrat (10) kleiner als 1 % ist.

5. Schale (100) nach Anspruch 3, wobei das erste Farbmittel ein Spinell-Farbmittel ist, wobei die zweite Region (12) Aluminiumoxid umfasst und ein Massengehalt des Aluminiumoxids in der zweiten Region (12) in einem Bereich von 3 % bis 20 % ist;
wobei die erste Region (11) Aluminiumoxid umfasst und ein Massengehalt des Aluminiumoxids in der ersten Region (11) kleiner als oder gleich 20 % ist.

6. Schale (100) nach Anspruch 1, wobei ein optischer Durchlässigkeitsgrad der zweiten Region (12) größer als 40 % ist;
wobei, nach Masseprozenten, Materialien der zweiten Region (12) 0,2 %-0,5 % Aluminiumoxid, 0,5 %-1 % Siliziumdioxid, 2 %-10 % Stabilisator und einen Rest von Zirkondioxid umfassen.

7. Schale (100) nach Anspruch 1, ferner umfassend eine Farbschicht (20), angeordnet auf der Oberfläche des Keramiksubstrats (10), wobei die Farbschicht (20) die zweite Region (12) abdeckt und wobei die Farbschicht (20) einen Farbunterschied zur ersten Region (11) aufweist; wobei ein optischer Durchlässigkeitsgrad der zweiten Region (12) größer als 40 % ist.

8. Schale (100) nach Anspruch 1, wobei die erste Region (11) und die Abstufungsregion (13) aneinander angrenzend angeordnet sind, und wobei die zweite Region (12) und die Abstufungsregion (13) aneinander angrenzend angeordnet sind;
wobei ein Wert des Farbunterschieds zwischen der ersten Region (11) und der zweiten Region (12) größer als 2 ist; wobei eine Dichte des Keramiksubstrats (10) größer als 6 g/cm³ ist, eine Biegefestigkeit des Keramiksubstrats (10) größer als 800 MPa ist, eine Bruchzähigkeit des Keramiksubstrats (10) größer als 7 MPa*m^{1/2} ist, eine Vickers-Härte des Keramiksubstrats (10) größer als 500 HV 0,1 ist und eine Oberflächenrauigkeit des Keramiksubstrats (10) kleiner als 0,01 µm ist.

9. Herstellungsverfahren für eine Schale (100), **dadurch gekennzeichnet, dass** es Folgendes umfasst:
Bereitstellen (101) eines ersten Keramikgrünkörpers und eines zweiten Keramikgrünkörpers, wobei der erste Keramikgrünkörper und der zweite Keramikgrünkörper einen Farbunterschied aufweisen und wobei eine Vickers-Härte von jedem aus dem ersten Keramikgrünkörper und dem zweiten Keramikgrünkörper größer als oder gleich 10 HV 0,1 ist;
Spleißen (102) des ersten Keramikgrünkörpers und des zweiten Keramikgrünkörpers zum Erhalten eines gespleißten Keramikgrünkörpers und dann Pressen des gespleißten Keramikgrünkörpers zum Bilden eines Keramiksubstratgrünkörpers, wobei ein Dichteunterschied zwischen dem ersten Keramikgrünkörper und dem zweiten Keramikgrünkörper im Keramiksubstratgrünkörper kleiner als 0,08 g/cm³ ist; und
Durchführen (103) des Klebstoffaustreibens und Sinterns am Keramiksubstratgrünkörper zum Erhalten eines Keramiksubstrats (10), dadurch die Schale (100) nach einem der Ansprüche 1-8 erhaltend.

10. Herstellungsverfahren nach Anspruch 9, wobei das Bereitstellen eines ersten Keramikgrünkörpers und eines zweiten Keramikgrünkörpers Folgendes umfasst:
Bereitstellen eines ersten Keramikrohmaterials und eines zweiten Keramikrohmaterials, wobei ein Unterschied zwischen medianen Partikeldurchmessern D50 des ersten Keramikrohmaterials und des zweiten Keramikrohmaterials kleiner als 30 µm ist, ein Unterschied zwischen Schüttdichten des ersten Keramikrohmaterials und des zweiten Keramikrohmaterials kleiner als 0,2 g/cm³ ist;
nach dem Vorpressen, Verarbeiten des ersten Keramikrohmaterials zum ersten Keramikgrünkörper und Verarbeiten des zweiten Keramikrohmaterials zum zweiten Keramikgrünkörper.

11. Herstellungsverfahren nach Anspruch 10, wobei die mediane Partikelgröße D50 des ersten Keramikrohmaterials in einem Bereich von 50 µm bis 100 µm ist, die Schüttdichte des ersten Keramikrohmaterials in einem Bereich von 1,2 g/cm³ bis 1,8 g/cm³ ist; die mediane Partikelgröße D50 des zweiten Keramikrohmaterials in einem Bereich von 50 µm bis 100 µm ist und die Schüttdichte des zweiten Keramikrohmaterials in einem Bereich von 1,2 g/cm³ bis 1,8 g/cm³ ist;
wobei das Vorpressen Verarbeitung bei einem Druck in einem Bereich von 5 MPa bis 20 MPa umfasst, eine Dichte von jedem aus dem ersten Keramikgrünkörper und dem zweiten Keramikgrünkörper in einem Bereich von 2,2 g/cm³ bis 2,5 g/cm³ ist, ein Dichteunterschied zwischen dem ersten Keramikgrünkörper und dem zweiten Keramikgrünkörper kleiner als 0,2 g/cm³ ist und eine Vickers-Härte von jedem aus dem ersten Keramikgrünkörper und dem zweiten Keramikgrünkörper in einem Bereich von 10 HV 0,1 bis 70 HV 0,1 ist.

12. Herstellungsverfahren nach Anspruch 9, wobei das Spleißen des ersten Keramikgrünkörpers und des zweiten Keramikgrünkörpers zum Erhalten eines gespleißten Keramikgrünkörpers und dann Pressen des gespleißten Keramikgrünkörpers zum Bilden eines Keramiksubstratgrünkörpers Folgendes umfasst:
Spleißen des ersten Keramikgrünkörpers und des zweiten Keramikgrünkörpers zum Bilden des Keramiksubstratgrünkörpers durch abschließendes Pressen und isostatisches Pressen, wobei das abschließende Pressen Verarbeiten bei einem Druck in einem Bereich von 50 MPa bis 80 MPa umfasst und das isostatische Pressen Verarbeiten bei einem Druck in einem Bereich von 100 MPa bis 200 MPa umfasst.

13. Herstellungsverfahren nach Anspruch 12, wobei ein Dichteunterschied zwischen dem ersten Keramikgrünkörper und dem zweiten Keramikgrünkörper nach dem abschließenden Pressen kleiner als 0,15 g/cm³ ist, eine Dichte des Keramiksubstratgrünkörpers nach dem abschließenden Pressen größer als 3 g/cm³ ist und eine Dichte des Keramiksubstratgrünkörpers nach dem isostatischen Pressen größer als 3,1 g/cm³ ist.

14. Herstellungsverfahren nach Anspruch 9, wobei das Klebstoffaustreiben Verarbeiten bei einer Temperatur in einem Bereich von 300 °C bis 500 °C über 12 Stunden bis 24 Stunden umfasst und das Sintern Verarbeiten bei einer Temperatur in einem Bereich von 1300 °C bis 1500 °C über 2 Stunden bis 4 Stunden umfasst.

15. Elektronische Vorrichtung, umfassend die Schale (100) nach einem der Ansprüche 1 bis 8 und eine Hauptplatine.

## Revendications

1. Coque (100), comprenant un substrat en céramique (10), dans laquelle le substrat en céramique (10) comprend une première région (11), une seconde région (12), et une région de gradation (13) située entre la première région (11) et la seconde région (12) ;
la première région (11) présente une première couleur, la seconde région (12) présente une seconde couleur, et la première région (11) et la seconde région (12) ont une différence de couleur ;
une direction allant de la première région (11) à la seconde région (12) est une première direction, et la région de gradation (13) présente une gradation allant de la première couleur à la seconde couleur le long de la première direction ; et
une surface du substrat en céramique (10) est pourvue d'une première ligne de limite (14) et d'une seconde ligne de limite (15), la première ligne de limite (14) est située entre la première région (11) et la région de gradation (13), la seconde ligne de limite (15) est située entre la seconde région (12) et la région de gradation (13) ;
**caractérisée en ce qu'**une rectitude d'au moins une de la première ligne de limite (14) et de la seconde ligne de limite (15) est inférieure à 0,5 mm, dans laquelle la rectitude est une valeur maximum d'une distance verticale entre un sommet d'onde et un creux d'onde d'une courbe définie par l'au moins une de la première ligne de limite (14) et de la seconde ligne de limite (15).

2. Coque (100) selon la revendication 1, dans laquelle la rectitude d'au moins une de la première ligne de limite (14) et de la seconde ligne de limite (15) est inférieure à 0,3 mm ;
dans laquelle la première ligne de limite (14) est parallèle à la seconde ligne de limite (15) ; et
dans laquelle une taille de la région de gradation (13) dans la première direction est inférieure ou égale à 20 mm.

3. Coque (100) selon la revendication 1, dans laquelle la première région (11) comprend un premier colorant, et une teneur massique du premier colorant dans la première région (11) est dans une plage de 0,1 % à 10 % ; la seconde région (12) comprend un second colorant, et une teneur massique du second colorant dans la seconde région (12) est inférieure ou égale à 10 %.

4. Coque (100) selon la revendication 3, dans laquelle la teneur massique du premier colorant dans la première région (11) est dans une plage de 4 % à 10 %, la teneur massique du second colorant dans la seconde région (12) est dans une plage de 0 % à 2 %, et au moins un du premier colorant et du second colorant est un colorant non-spinelle ;
dans laquelle un matériau du substrat en céramique (10) comprend de l'oxyde d'aluminium, et une teneur massique de l'oxyde d'aluminium dans le substrat en céramique (10) est inférieure à 1 %.

5. Coque (100) selon la revendication 3, dans laquelle le premier colorant est un colorant spinelle, dans laquelle la seconde région (12) comprend de l'oxyde d'aluminium, et une teneur massique de l'oxyde d'aluminium dans la seconde région (12) est dans une plage de 3 % à 20 % ;
dans laquelle la première région (11) comprend de l'oxyde d'aluminium, et une teneur massique de l'oxyde d'aluminium dans la première région (11) est inférieure ou égale à 20 %.

6. Coque (100) selon la revendication 1, dans laquelle une transmittance optique de la seconde région (12) est supérieure à 40 % ;
dans laquelle, en pourcentages massiques, des matériaux de la seconde région (12) comprennent de 0,2 % à 0,5 % d'oxyde d'aluminium, de 0,5 % à 1 % de dioxyde de silicium, de 2 % à 10 % de stabilisateur, et un reste de zircone.

7. Coque (100) selon la revendication 1, comprenant en outre une couche de couleur (20) disposée sur la surface du substrat en céramique (10), dans laquelle la couche de couleur (20) couvre la seconde région (12), et la couche de couleur (20) a une différence de couleur avec la première région (11) ;
dans laquelle une transmittance optique de la seconde région (12) est supérieure à 40 %.

8. Coque (100) selon la revendication 1, dans laquelle la première région (11) et la région de gradation (13) sont agencées de façon adjacente l'une à l'autre, et la seconde région (12) et la région de gradation (13) sont agencées de façon adjacente l'une à l'autre ;
dans laquelle une valeur de la différence de couleur entre la première région (11) et la seconde région (12) est supérieure à 2 ;
dans laquelle une densité du substrat en céramique (10) est supérieure à 6 g/cm³, une résistance à la flexion du substrat en céramique (10) est supérieure à 800 MPa, une ténacité à la fracture du substrat en céramique (10) est supérieure à 7 MPa*m^{1/2}, une dureté Vickers du substrat en céramique (10) est supérieure à 500 HV 0.1, et une rugosité de surface du substrat en céramique (10) est inférieure à 0,01 µm.

9. Procédé de préparation pour une coque (100), **caractérisé en ce qu'**il comprend :
la fourniture (101) d'une première pièce crue en céramique et d'une seconde pièce crue en céramique, dans lequel la première pièce crue en céramique et la seconde pièce crue en céramique ont une différence de couleur, et une dureté Vickers de chacune de la première pièce crue en céramique et de la seconde pièce crue en céramique est supérieure ou égale à 10 HV 0.1 ;
l'assemblage (102) de la première pièce crue en céramique et de la seconde pièce crue en céramique pour obtenir une pièce crue en céramique assemblée, et puis le pressage de la pièce crue en céramique assemblée pour former une pièce crue de substrat en céramique, dans lequel une différence de densité entre la première pièce crue en céramique et la seconde pièce crue en céramique dans la pièce crue de substrat en céramique est inférieure à 0,08 g/cm³ ; et
la réalisation (103) de déchargement de colle et de frittage sur la pièce crue de substrat en céramique pour obtenir un substrat en céramique (10), ainsi obtenant la coque (100) telle que revendiquée dans l'une quelconque des revendications 1 à 8.

10. Procédé de préparation selon la revendication 9, dans lequel la fourniture d'une première pièce crue en céramique et d'une seconde pièce crue en céramique comprend :
la fourniture d'un premier matériau brut en céramique et d'un second matériau brut en céramique, dans lequel une différence entre des diamètres particulaires médians D50 du premier matériau brut en céramique et du second matériau brut en céramique est inférieure à 30 µm, une différence entre des densités apparentes du premier matériau brut en céramique et du second matériau brut en céramique est inférieure à 0,2 g/cm³ ;
après le pré-pressage, la fabrication du premier matériau brut en céramique en la première pièce crue en céramique et la fabrication du second matériau brut en céramique en la seconde pièce crue en céramique.

11. Procédé de préparation selon la revendication 10, dans lequel la taille particulaire médiane D50 du premier matériau brut en céramique est dans une plage de 50 µm à 100 µm, la densité apparente du premier matériau brut en céramique est dans une plage de 1,2 g/cm³ à 1,8 g/cm³ ; la taille particulaire médiane D50 du second matériau brut en céramique est dans une plage de 50 µm à 100 µm, et la densité apparente du second matériau brut en céramique est dans une plage de 1,2 g/cm³ à 1,8 g/cm³ ;
le pré-pressage comprend le traitement à une pression dans une plage de 5 MPa à 20 MPa, une densité de chacune de la première pièce crue en céramique et de la seconde pièce crue en céramique est dans une plage de 2,2 g/cm³ à 2,5 g/cm³, une différence de densité entre la première pièce crue en céramique et la seconde pièce crue en céramique est inférieure à 0,2 g/cm³, et une dureté Vickers de chacune de la première pièce crue en céramique et de la seconde pièce crue en céramique est dans une plage de 10 HV 0.1 à 70 HV 0.1.

12. Procédé de préparation selon la revendication 9, dans lequel l'assemblage de la première pièce crue en céramique et de la seconde pièce crue en céramique pour obtenir une pièce crue en céramique assemblée et puis le pressage de la pièce crue en céramique assemblée pour former une pièce crue de substrat en céramique comprend :
l'assemblage de la première pièce crue en céramique et de la seconde pièce crue en céramique pour former la pièce crue de substrat en céramique par pressage final et pressage isostatique, dans lequel le pressage final comprend le traitement à une pression dans une plage de 50 MPa à 80 MPa, et le pressage isostatique comprend le traitement à une pression dans une plage de 100 MPa à 200 MPa.

13. Procédé de préparation selon la revendication 12, dans lequel une différence de densité entre la première pièce crue en céramique et la seconde pièce crue en céramique après le pressage final est inférieure à 0,15 g/cm³, une densité de la pièce crue de substrat en céramique après le pressage final est supérieure à 3 g/cm³, et une densité de la pièce crue de substrat en céramique après le pressage isostatique est supérieure à 3,1 g/cm³.

14. Procédé de préparation selon la revendication 9, dans lequel le déchargement de colle comprend le traitement à une température dans une plage de 300 °C à 500 °C pendant 12 heures à 24 heures ; et le frittage comprend le traitement à une température dans une plage de 1 300 °C à 1 500 °C pendant 2 heures à 4 heures.

15. Dispositif électronique, comprenant la coque (100) selon l'une quelconque des revendications 1 à 8 et une carte mère.
